# EUROPEAN PATENT APPLICATION

(11) **EP 4 564 402 A1**
(43) Date of publication of application: **04.06.2025**
(21) Application number: 24213887.3
(22) Date of filing: 19.11.2024
(51) Int. Cl.: H01L 21/20, H10B 12/00

(54) **METHOD OF MANUFACTURING SEMICONDUCTOR MEMORY DEVICE**

(30) Priority: 28.11.2023 KR 20230168234
(71) Applicant: Samsung Electronics Co., Ltd., Suwon-si, Gyeonggi-do 16677 (KR)
(72) Inventor: KIM, Jinbum, 16677 Suwon-si (KR); JANG, Sunguk, 16677 Suwon-si (KR); ZOH, Inhae, 16677 Suwon-si (KR); KIM, Bitna, 16677 Suwon-si (KR); YANG, Suk, 16677 Suwon-si (KR); JANG, Sunghwan, 16677 Suwon-si (KR); HAN, Soobin, 16677 Suwon-si (KR)
(74) Representative: Marks & Clerk LLP

(57) **Abstract**

A method of manufacturing a semiconductor memory device includes forming, on a substrate, a channel structure including a channel pattern; forming, on the channel structure, a silicide material layer including an alloy of a semiconductor material and a metal including a eutectic composition; forming a sacrificial semiconductor layer between the channel structure and the silicide material layer and forming a mold layer surrounding the sacrificial semiconductor layer; forming a capacitor hole by removing the sacrificial semiconductor layer; forming a lower electrode that fills the capacitor hole; removing the mold layer; forming a capacitor dielectric layer that covers a surface of the lower electrode; and forming an upper electrode that covers the capacitor dielectric layer.

## Description

### BACKGROUND

One or more example embodiments of the disclosure relate to a method of manufacturing a semiconductor memory device. More particularly, one or more example embodiments of the disclosure relate to a method of manufacturing a semiconductor memory device that includes a capacitor structure.

Electronic apparatuses are becoming more compact and lightweight according to rapid development of electronic industries and user's demands. Therefore, semiconductor memory devices need to have a high degree of integration for use in the electronic apparatuses, and thus, design rules for components of the semiconductor memory devices are decreasing. Accordingly, it is difficult to ensure the reliability of semiconductor memory devices.

### SUMMARY

One or more example embodiments of the disclosure provide a method of manufacturing a semiconductor memory device, which may improve the reliability of the semiconductor memory device by securing the capacitance of a capacitor structure.

According to an aspect of an example embodiment of the disclosure, there is provided a method of manufacturing a semiconductor memory device, the method including forming, on a substrate, a channel structure including a channel pattern; forming, on the channel structure, a silicide material layer including an alloy of a semiconductor material and a metal, the metal including a eutectic composition; forming a sacrificial semiconductor layer between the channel structure and the silicide material layer, and forming a mold layer surrounding the sacrificial semiconductor layer; forming a capacitor hole by removing the sacrificial semiconductor layer; forming a lower electrode that fills the capacitor hole; removing the mold layer; forming a capacitor dielectric layer that covers a surface of the lower electrode; and forming an upper electrode that covers the capacitor dielectric layer.

According to an aspect of an example embodiment of the disclosure, there is provided a method of manufacturing a semiconductor memory device, the method including forming a plurality of word lines, a plurality of channel structures, and a plurality of bit lines on a substrate, wherein the plurality of word lines extend in a first horizontal direction, wherein the plurality of channel structures are adjacent to the plurality of word lines and arranged in rows in the first horizontal direction, each channel structure of the plurality of channel structures including a channel pattern extending in a vertical direction, and wherein the plurality of bit lines extend in a second horizontal direction, different from the first horizontal direction, and are electrically connected to first ends of the plurality of channel patterns; respectively forming, on the plurality of channel structures, a plurality of silicide material layers, each silicide material layer of the plurality of silicide material layers including an alloy of a semiconductor material and a metal, the metal including a eutectic composition; performing a metal-induced crystallization to convert the plurality of silicide material layers into a plurality of induced silicide material layers having a circular planar shape; forming a plurality of sacrificial semiconductor layers between the plurality of induced silicide material layers and upper surfaces of the plurality of channel structures, and forming a mold layer surrounding the plurality of sacrificial semiconductor layers; forming a plurality of capacitor holes by removing the plurality of sacrificial semiconductor layers; forming a plurality of lower electrodes that respectively fill the plurality of capacitor holes and are respectively electrically connected to second ends of the plurality of channel patterns; removing the mold layer; forming a capacitor dielectric layer that covers surfaces of the plurality of lower electrodes; and forming an upper electrode that covers the capacitor dielectric layer.

According to another aspect of the inventive concept, there is provided a method of manufacturing a semiconductor memory device, the method including forming a plurality of word lines, a plurality of back gate lines, a plurality of channel patterns, and a plurality of bit lines on a substrate, wherein the plurality of word lines extend in a first horizontal direction, wherein the plurality of back gate lines extend in the first horizontal direction and spaced apart from the plurality of word lines in a second horizontal direction different from the first horizontal direction, wherein the plurality of channel patterns are arranged between one word line, among the plurality of word lines, and one back gate line adjacent to the one word line, among the plurality of back gate lines, the plurality of channel patterns extending in a vertical direction, and wherein the plurality of bit lines extend below the plurality of channel patterns in the second horizontal direction different from the first horizontal direction and are electrically connected to first ends of the plurality of channel patterns; forming a plurality of connection structures by implanting impurities into upper portions of the plurality of channel patterns; forming, on the plurality of connection structures, a plurality of silicide material layers, each silicide material layer of the plurality of silicide material layers comprising an alloy of a semiconductor material and a metal, the metal comprising a eutectic composition; forming a plurality of sacrificial semiconductor layers, a mold layer, and a plurality of support patterns on the plurality of connection structures; forming a plurality of capacitor holes by removing the plurality of sacrificial semiconductor layers; forming a plurality of lower electrodes that respectively fill the plurality of capacitor holes and are respectively electrically connected to second ends of the plurality of channel patterns; removing the mold layer; forming a capacitor dielectric layer that covers surfaces of the plurality of lower electrodes and surfaces of the plurality of support patterns; and forming an upper electrode that covers the capacitor dielectric layer, wherein each sacrificial semiconductor layer of the plurality of sacrificial semiconductor layers comprises a plurality of sub-sacrificial semiconductor layers having a cylindrical shape, and the mold layer comprises a plurality of sub-mold layers, and wherein the forming the plurality of sacrificial semiconductor layers, the mold layer, and the plurality of support patterns comprises: heating and converting the plurality of silicide material layers into a plurality of induced silicide material layers having a circular planar shape; a first operation of forming, between the plurality of induced silicide material layers and upper surfaces of the plurality of connection structures, one sub-sacrificial semiconductor layer, among the plurality of sub-sacrificial semiconductor layers, by injecting a semiconductor material precursor and performing a metal-induced crystallization; a second operation of forming one sub-mold layer, among the plurality of sub-mold layers, that surrounds a portion of a side surface of the one sub-sacrificial semiconductor layer; a third operation of forming one support pattern, among the plurality of support patterns, which covers a side surface of an upper portion of the one sub-sacrificial semiconductor layer; and repeating the first operation, the second operation, and the third operation at least three times.

At least some of the above and other features of the invention are set out in the claims.

### BRIEF DESCRIPTION OF THE DRAWINGS

Example embodiments will be more clearly understood from the following detailed description taken in conjunction with the accompanying drawings in which:
FIG. 1 is a plan layout showing a semiconductor memory device according to one or more example embodiments;
FIGS. 2A to 2D are cross-sectional views showing the semiconductor memory device according to one or more example embodiments;
FIGS. 3A to 18 are perspective views and cross-sectional views illustrating a method of manufacturing a semiconductor memory device according to one or more example embodiments and FIG. 19 is a cross-sectional view showing the semiconductor memory device according to one or more example embodiments;
FIGS. 20 to 25 are cross-sectional views illustrating a method of manufacturing a semiconductor memory device according to one or more example embodiments;
FIGS. 26A to 26E are conceptual diagrams illustrating a method of forming a sacrificial structure, which is used in the method of manufacturing the semiconductor memory device according to one or more example embodiments;
FIGS. 27 to 30 are cross-sectional views illustrating a method of manufacturing a semiconductor memory device according to one or more example embodiments;
FIGS. 32A to 35B are perspective views and cross-sectional views illustrating a method of manufacturing a semiconductor memory device according to one or more example embodiments and FIG. 36 is a cross-sectional view showing the semiconductor memory device according to one or more example embodiments;
FIGS. 37 to 44 are cross-sectional views illustrating a method of manufacturing a semiconductor memory device according to one or more example embodiments and FIG. 45 is a cross-sectional view showing the semiconductor memory device according to one or more example embodiments; and
FIG. 46 is a plan layout showing a semiconductor memory device according to one or more example embodiments.

### DETAILED DESCRIPTION

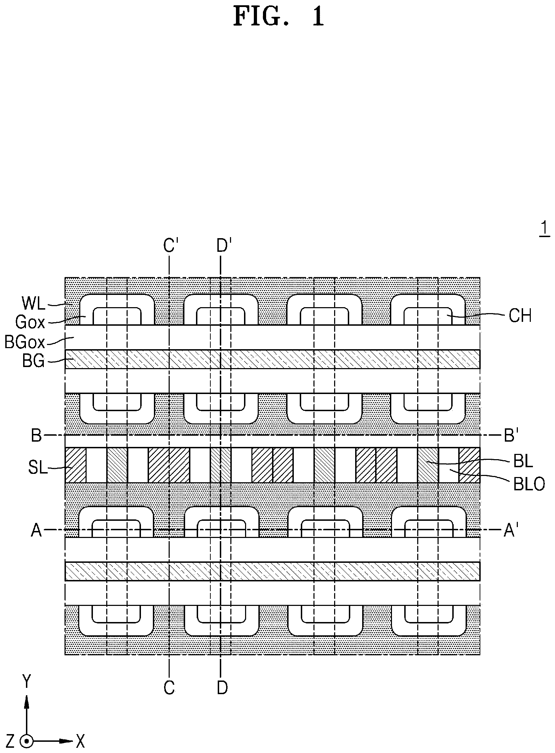

FIG. 1 is a plan layout showing a semiconductor memory device 1 according to one or more example embodiments. FIG. 1 may be a plan view when viewed from a vertical direction (e.g., Z direction).

Referring to FIG. 1, the semiconductor memory device 1 may include a plurality of word lines WL extending in a first horizontal direction (e.g., X direction), a plurality of bit lines BL extending in a second horizontal direction (e.g., Y direction) different from the first horizontal direction (X direction), a plurality of back gate lines BG extending in the first horizontal direction (X direction), and a plurality of channel patterns CH extending in the vertical direction (Z direction). The first horizontal direction (X direction) and the second horizontal direction (Y direction) may be perpendicular to each other. In some embodiments, the semiconductor memory device 1 may include a dynamic random access memory (DRAM). A horizontal direction may be a direction that is parallel to an upper surface of a substrate of the semiconductor memory device 1. A vertical direction may be a direction perpendicular to the upper surface of the substrate. The vertical direction may define a height direction, such that elements or components that are "above" other elements or components are located further along the vertical direction than the other elements or components (or at least have some portion that is located further along the vertical direction than the other elements or components). Similarly, an "upper" section of an element or component may be above a "lower" section of an element or component. It will be appreciated that these directions and relative positions are defined relative to the structure of the semiconductor memory device 1, and therefore need not imply any particular orientation of the semiconductor memory device 1 in use. As used herein, the singular forms "a", "an", and "the" are intended to include the plural forms as well, unless the context clearly indicates otherwise. Additionally, the description may be specific to a portion of the semiconductor memory device and the described structure may be repeated in other portions of the semiconductor memory device. For example, the described structure may be an individual element of an array of elements forming the semiconductor memory device. Accordingly, where the structure of a single element of a plurality of elements has been described, this structure may equally apply to other elements of the plurality of elements.

The plurality of word lines WL and the plurality of back gate lines BG may be spaced apart from each other in the second horizontal direction (Y direction) and extend, parallel to each other, in the first horizontal direction (X direction). Each of the plurality of back gate lines BG may be located between a pair of adjacent word lines WL among the plurality of word lines WL. The number of word lines WL may be approximately twice the number of back gate lines BG. For example, the plurality of word lines WL and the plurality of back gate lines BG may be arranged such that two word lines WL among the plurality of word lines WL and one back gate line BG among the plurality of back gate lines BG are alternately arranged in the second horizontal direction (Y direction). That is, two word lines WL may be arranged between each pair of adjacent back gate lines BG.

The plurality of channel patterns CH may be arranged in a row in the first horizontal direction (X direction) between one word line WL and one back gate line BG that are adjacent to each other among the plurality of word lines WL and the plurality of back gate lines BG. A plurality of rows of channel patterns CH extending in the first horizontal direction (X direction) may be spaced apart from each other in the second horizontal direction (Y direction). The plurality of channel patterns CH may be arranged in one or more rows in the second horizontal direction (Y direction) (e.g. in one or more columns). For example, each of the plurality of channel patterns CH arranged in a row in the second horizontal direction (Y direction) may be located between one word line WL and one back gate line BG that are adjacent to each other in the second horizontal direction (Y direction). For example, a pair of channel patterns CH spaced apart from each other in the second horizontal direction (Y direction) with one of the plurality of back gate lines BG therebetween may have shapes symmetrical to each other with respect to the one back gate line BG.

Each of the plurality of channel patterns CH may include a first sidewall facing the back gate line BG and a second sidewall facing the word line WL and connected to edges of the first sidewall. The first sidewall may be flat and the second sidewall may be curved. That is, in a plan view, the first sidewall may have a straight line shape and the second sidewall may have a curved shape. For example, in a plan view, each of the plurality of channel patterns CH may have a rectangular-like shape, in which two corners facing the word line WL are rounded, or may have a shape in which the second sidewall has a shape of a circular arc or an elliptical arc.

A gate insulating layer Gox may be located between the channel pattern CH and the word line WL and a back gate insulating layer BGox may be located between the channel pattern CH and the back gate line BG. In some embodiments, the gate insulating layer Gox may surround at least a portion of the channel pattern CH in a plan view. In some embodiments, the back gate insulating layers BGox may extend in the first horizontal direction (X direction) along both sides of the back gate line BG in the second horizontal direction (Y direction). The first sidewall of the channel pattern CH may be covered with the back gate insulating layer BGox and the second sidewall of the channel pattern CH may be covered with the gate insulating layer Gox. FIG. 1 illustrates that the gate insulating layer Gox covers only the second sidewall of the channel pattern CH, but the embodiment is not limited thereto. For example, the gate insulating layer Gox may be located between the first sidewall of the channel pattern CH and the back gate insulating layer BGox and thus completely surround the channel pattern CH in a plan view.

The plurality of bit lines BL may be spaced apart from each other in the first horizontal direction (X direction) and extend, parallel to each other, in the second horizontal direction (Y direction). The plurality of bit lines BL may extend in the second horizontal direction (Y direction) and be electrically connected to the plurality of channel patterns CH. For example, the plurality of bit lines BL may be electrically connected to a first end (e.g. a lower end) of both ends of each of the plurality of channel patterns CH in the vertical direction (Z direction). One bit line BL may be electrically connected to the channel patterns CH that are arranged in a row in the second horizontal direction (Y direction). A cover insulating layer BLO may cover the plurality of bit lines BL. The cover insulating layer BLO may conformally cover the plurality of bit lines BL but not completely fill spaces between the plurality of bit lines BL. A shield conductive layer SL may cover the plurality of bit lines BL with the cover insulating layer BLO therebetween. The spaces between the plurality of bit lines BL that are not completely filled by the cover insulating layer BLO may be filled with the shield conductive layer SL.

FIG. 1 illustrates that a plurality of cover insulating layers BLO are arranged on both sides of each of the plurality of bit lines BL and a plurality of shield conductive layers SL are arranged between two cover insulating layers BLO that respectively cover sidewalls of two adjacent bit lines BL that face each other. However, FIG. 1 is only a conceptual illustration of a plan view of the semiconductor memory device 1, and the embodiment is not limited thereto. For example, each of the shield conductive layer SL and the cover insulating layer BLO, shown as a plurality of segments in FIG. 1, may be connected to each other below the plurality of bit lines BL to form a single body.

A portion of the shield conductive layer SL located between two adjacent bit lines BL may have a shape of a line extending in the second horizontal direction (Y direction). Between two adjacent bit lines BL, a portion of the cover insulating layer BLO located between the bit line BL and the shield conductive layer SL may have a shape of a line extending in the second horizontal direction (Y direction). For example, portions of a pair of the cover insulating layers BLO that are spaced apart from each other in the first horizontal direction (X direction) and have a shape of a line extending in the second horizontal direction (Y direction) may be arranged between the two adjacent bit lines BL.

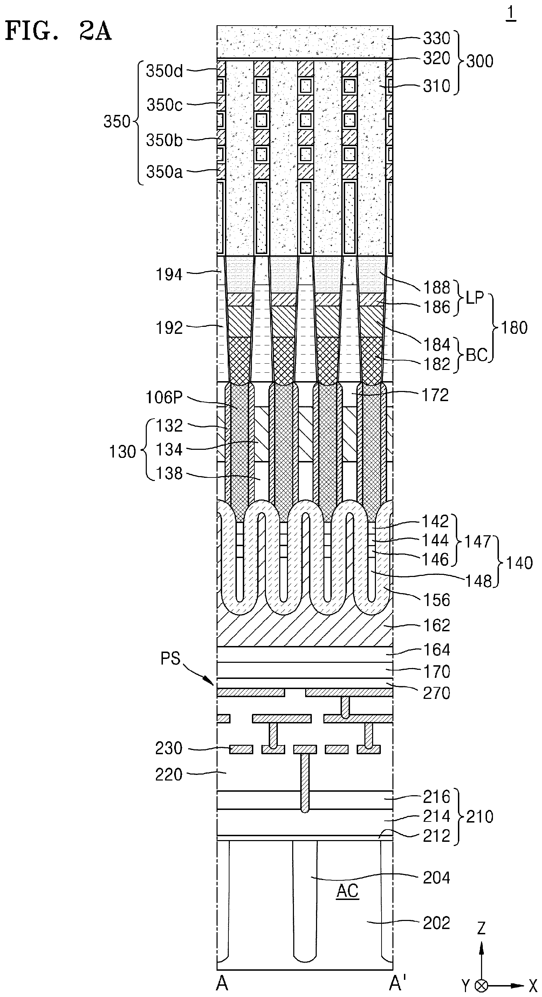

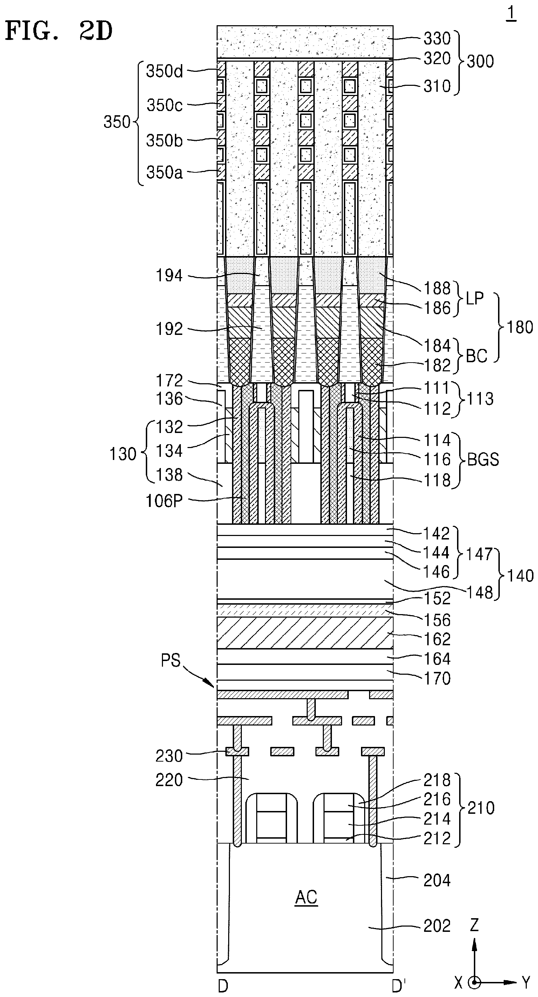

The bit line BL, the word line WL, the channel pattern CH adjacent to a portion of the word line WL intersecting with the bit line BL in a plan view, and the gate insulating layer Gox between the word line WL and the channel pattern CH may constitute a vertical channel transistor. A capacitor structure 300 (see FIGS. 2A and 2D) may be disposed on the vertical channel transistor, and the vertical channel transistor and the capacitor structure 300 may form a memory cell. A lower electrode 310 (see FIGS. 2A and 2D) of the capacitor structure 300 may be electrically connected to the channel pattern CH.

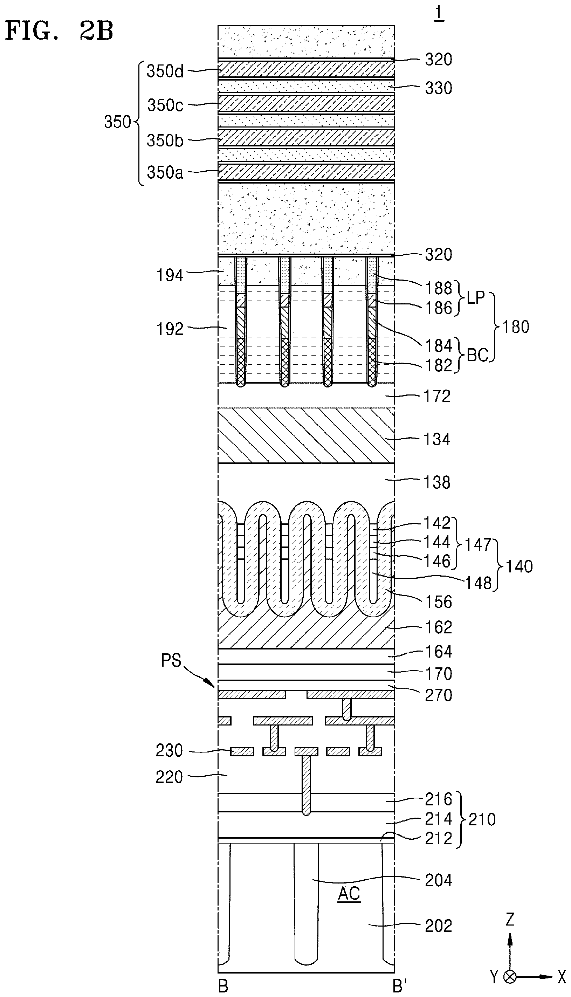

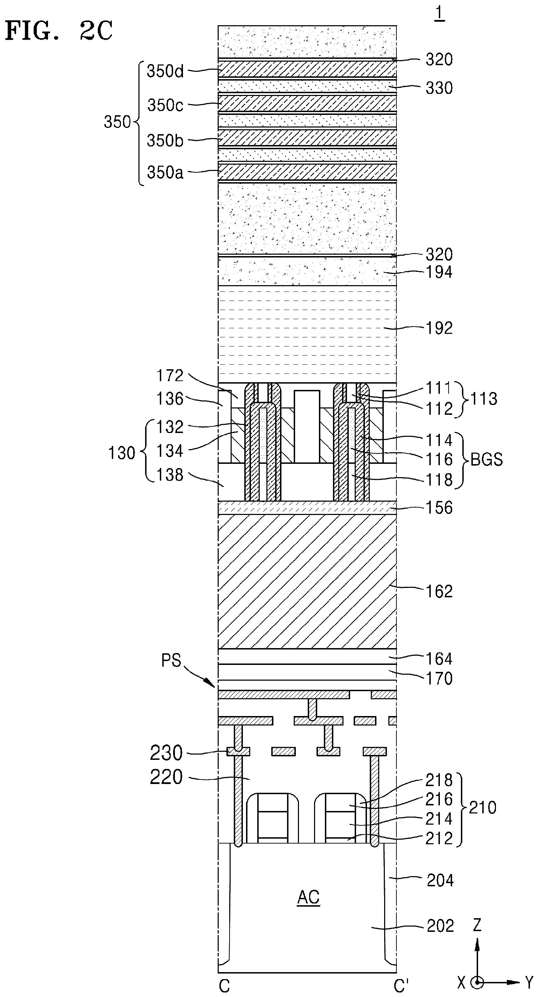

FIGS. 2A to 2D are cross-sectional views showing the semiconductor memory device 1 according to one or more example embodiments. Specifically, FIG. 2A is a cross-sectional view of the semiconductor memory device 1 taken along line A-A' of FIG. 1, FIG. 2B is a cross-sectional view of the semiconductor memory device 1 taken along line B-B' of FIG. 1, FIG. 2C is a cross-sectional view of the semiconductor memory device 1 taken along line C-C' of FIG. 1, and FIG. 2D is a cross-sectional view of the semiconductor memory device 1 taken along line D-D' of FIG. 1.

Referring to FIGS. 2A to 2D together, the semiconductor memory device 1 includes a plurality of bit line structures 140 on a peripheral circuit structure PS, a plurality of back gate structures BGS on the plurality of bit line structures 140, a transistor structure including a plurality of word line structures 130 and a plurality of channel patterns 106P, a plurality of capacitor structures 300 on the transistor structure, and a plurality of connection structures 180 electrically connecting the plurality of channel patterns 106P to the plurality of capacitor structures 300. The plurality of capacitor structures 300 may be formed by sequentially stacking a plurality of lower electrodes 310 (otherwise known as first electrodes), a capacitor dielectric layer 320, and an upper electrode 330 (otherwise known as a second electrode). The plurality of channel patterns 106P may be electrically connected to the plurality of lower electrodes 310 via the plurality of connection structures 180. The plurality of word line structures 130 and the plurality of channel patterns 106P of the transistor structure constitute a plurality of transistors. Each of the plurality of transistors may include a vertical channel transistor (VCT).

The plurality of back gate structures BGS may each include a back gate insulating layer 114, a back gate line 116, and a back gate capping layer 118. The back gate insulating layer 114 may be located between the back gate line 116 and the channel pattern 106P. The back gate capping layer 118 may cover a bottom surface of the back gate line 116. In some embodiments, on a plane (Y-Z plane) formed by the second horizontal direction (Y direction) and the vertical direction (Z direction), the back gate insulating layer 114 may have a reversed (e.g. inverted) U-shape and cover a side surface of the back gate capping layer 118, a side surface of the back gate line 116, and an the upper surface of back gate line 116. The plurality of word line structures 130 may each include a gate insulating layer 132, a word line 134, and a gate capping layer 138. The gate insulating layer 132 may be located between the word line 134 and the channel pattern 106P. The gate capping layer 138 may cover a bottom surface of the word line 134. The back gate insulating layer 114, the back gate line 116, the gate insulating layer 132, and the word line 134 may include the back gate insulating layer BGox, the back gate line BG, the gate insulating layer Gox, and the word line WL, respectively, shown in FIG. 1. The plurality of back gate structures BGS and the plurality of word line structures 130 may be spaced apart from each other in the second horizontal direction (Y direction) and extend, parallel to each other, in the first horizontal direction (X direction).

The back gate insulating layer 114 may include at least one of silicon oxide, silicon nitride, silicon oxynitride, oxide/nitride/oxide (ONO), and a high-k dielectric having a higher dielectric constant than the silicon oxide. For example, the back gate insulating layer 114 may have a dielectric constant of about 10 to about 25. The back gate line 116 may include a semiconductor material, a metal material, a conductive metal nitride, or a combination thereof. In some embodiments, the back gate line 116 may include doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, or a combination thereof. The back gate capping layer 118 may include silicon oxide.

The gate insulating layer 132 may include at least one of silicon oxide, silicon nitride, silicon oxynitride, ONO, and a high-k dielectric having a higher dielectric constant than the silicon oxide. For example, the gate insulating layer 132 may have a dielectric constant of about 10 to about 25. The word line 134 may include a semiconductor material, a metal material, a conductive metal nitride, or a combination thereof. In some embodiments, the word line 134 may include doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, or a combination thereof. The gate capping layer 138 may include silicon nitride.

An isolation insulating layer 136 may be located between a pair of word lines 134, wherein the pair of word lines 134 are between a pair of channel patterns 106P adjacent to each other in the second horizontal direction (Y direction). The isolation insulating layer 136 may include silicon oxide. A buried capping layer 172 may cover a pair of word lines 134, which are provided between a pair of channel patterns 106P adj acent to each other in the second horizontal direction (Y direction), and cover the isolation insulating layer 136 that is provided between the pair of word lines 134. For example, the buried capping layer 172 may include silicon nitride. The gate capping layer 138 may cover the bottom surface of the word line 134 and a bottom surface of the isolation insulating layer 136.

A plurality of base insulating structures 113 may be disposed on the plurality of back gate structures BGS. The back gate structure BGS and the base insulating structure 113 disposed on the back gate structure BGS may be arranged between the pair of channel patterns 106P, which are adjacent to each other in the second horizontal direction (Y direction). The plurality of base insulating structures 113 may extend, parallel to each other, in the first horizontal direction (X direction). Each of the plurality of base insulating structures 113 may include a pair of lower insulating layers 111 covering a pair of channel patterns 106P, which are adjacent to each other in the second horizontal direction (Y direction), and an upper insulating layer 112 provided between the pair of lower insulating layers 111. For example, each of the lower insulating layers 111 may include oxide and the upper insulating layer 112 may include nitride.

The plurality of back gate lines 116 and the plurality of word lines 134 may be spaced apart from each other in the second horizontal direction (Y direction) and extend, parallel to each other, in the first horizontal direction (X direction). Each of the plurality of back gate lines 116 may be located between a pair of adjacent word lines 134 among the plurality of word lines 134. For example, two word lines 134 among the plurality of word lines 134 and one back gate line 116 among the plurality of back gate lines 116 may be arranged alternately in the second horizontal direction (Y direction).

The plurality of channel patterns 106P may be arranged in one or more rows in the first horizontal direction (X direction) between one word line 134 and one back gate line 116 that are adjacent to each other among the plurality of word lines 134 and the plurality of back gate lines 116. A plurality of rows of channel patterns 106P extending in the first horizontal direction (X direction) may be spaced apart from each other in the second horizontal direction (Y direction). The plurality of channel patterns 106P may be arranged in one or more rows (e.g. one or more columns) in the second horizontal direction (Y direction). For example, each of the channel patterns 106P arranged in a row in the second horizontal direction (Y direction) may be located between one word line 134 and one back gate line 116 that are adjacent to each other in the second horizontal direction (Y direction). The channel pattern 106P may include the channel pattern CH shown in FIG. 1.

The channel pattern 106P may include a semiconductor material. For example, the channel pattern 106P may include single crystalline silicon or polysilicon. In some embodiments, the channel pattern 106P may include an oxide semiconductor material. The channel pattern 106P may include at least one of a binary oxide semiconductor material or a ternary oxide semiconductor material including a first metal element, a ternary oxide semiconductor material including a first metal element and second metal element different from each other, and a quaternary oxide semiconductor material including a first metal element, a second metal element, and a third metal element different from each other.

The binary oxide semiconductor material or the ternary oxide semiconductor material may include, but not limited to, for example, any one of zinc oxide (ZnO or ZnₓO), gallium oxide (GaO or GaₓO), titanium oxide (TiO or TiₓO), tin oxide (SnO or SnₓO), zinc oxynitride (ZnON or ZnₓO_{y}N), indium zinc oxide (IZO or InₓZn_{y}O), gallium zinc oxide (GZO or GaₓZn_{y}O), tin zinc oxide (TZO or SnₓZn_{y}O), and tin gallium oxide (TGO or SnₓGa_{y}O). The quaternary oxide semiconductor material may include, but not limited to, for example, any one of indium gallium zinc oxide (IGZO or InₓGa_{y}Zn_{z}O), indium gallium silicon oxide (IGSO or InₓGa_{y}Si_{z}O), indium tin zinc oxide (ITZO or InₓSn_{y}Zn_{z}O), indium gallium tin oxide (IGTO or InₓGa_{y}Sn_{z}O), zirconium zinc tin oxide (ZZTO or ZrₓZn_{y}Sn_{z}O), hafnium indium zinc oxide (HIZO or HfₓIn_{y}Zn_{z}O), gallium zinc tin oxide (GZTO or GaₓZn_{y}Sn_{z}O), aluminium zinc tin oxide (AZTO or AlₓZn_{y}Sn_{z}O), ytterbium gallium zinc oxide (YGZO or YbₓGa_{y}Zn_{z}O), and indium aluminum zinc oxide (IAZO).

In some embodiments, the channel pattern 106P may include a crystalline oxide semiconductor material or an amorphous oxide semiconductor material. When the channel pattern 106P includes the crystalline oxide semiconductor material, the channel pattern 106P may include at least one of a single crystalline, polycrystalline, spinel, and c-axis aligned crystalline (CAAC). In some embodiments, the channel pattern 106P may be formed by stacking at least two layers that includes a first layer, including the crystalline oxide semiconductor material, and a second layer, including the amorphous oxide semiconductor material. For example, the channel pattern 106P may be formed by sequentially stacking a first layer including the crystalline oxide semiconductor material, a second layer including the amorphous oxide semiconductor material, and a third layer including the crystalline oxide semiconductor material.

Each of the plurality of bit line structures 140 may include a bit line 147 and an insulating capping line 148 for covering the bit line 147 (e.g., a bottom surface of the bit line 147). The plurality of bit line structures 140 may be spaced apart from each other in the first horizontal direction (X direction) and extend, parallel to each other, in the second horizontal direction (Y direction). A first end (e.g. a lower end) of both ends of each of the plurality of channel patterns 106P in the vertical direction (Z direction) may be electrically connected to a corresponding one of a plurality of bit lines 147. The plurality of bit lines 147 and a plurality of insulating capping lines 148 may be spaced apart from each other in the first horizontal direction (X direction) and extend, parallel to each other, in the second horizontal direction (Y direction). The plurality of bit lines 147 may be electrically connected to the plurality of channel patterns 106P, respectively. Each of the plurality of bit lines 147 may include polysilicon, metal, conductive metal nitride, conductive metal silicide, conductive metal oxide, or a combination thereof. For example, the bit line 147 may include, but not limited to, doped polysilicon, Al, Cu, Ti, Ta, Ru, W, Mo, Pt, Ni, Co, TiN, TaN, WN, WSi, NbN, TiAl, TiAlN, TiSi, TiSiN, TaSi, TaSiN, RuTiN, NiSi, CoSi, IrOₓ, RuOₓ, or a combination thereof. Also, the bit line 147 may include a two-dimensional semiconductor material. The two-dimensional semiconductor material may include, for example, graphene, carbon nanotubes, or a combination thereof. The bit line 147 may include a single layer or multi layers including the above-described conductive materials.

The bit line 147 may have a stack structure of a first line pattern 142, a second line pattern 144, and a third line pattern 146 which are sequentially stacked below the channel pattern 106P. For example, the first line pattern 142 may include a semiconductor material, and each of the second line pattern 144 and the third line pattern 146 may include a metal-based material. The second line pattern 144 and the third line pattern 146 may include different types of metal-based materials. For example, the first line pattern 142 may include doped polysilicon. For example, the second line pattern 144 may include titanium nitride (TiN) or TSN (Ti-Si-N), and the third line pattern 146 may include tungsten (W) or tungsten silicide (WSiₓ). In some embodiments, the second line pattern 144 may function as a diffusion barrier. The first line pattern 142 may be in contact with a lower surface of the channel pattern 106P. The insulating capping line 148 may cover the bottom surface of the bit line 147. The insulating capping line 148 may cover a lower surface of the third line pattern 146. For example, the insulating capping line 148 may include silicon nitride.

The cover insulating layer 156 may fill a portion of each space between the plurality of bit line structures 140. The cover insulating layer 156 may conformally cover the bottom surface of the plurality of bit line structures 140 but not completely fill spaces between the plurality of bit line structures 140. The cover insulating layer 156 may cover a bottom surface of the plurality of word line structures 130, a bottom surface of the plurality of back gate structures BGS, and a bottom surface of the plurality of bit line structures 140. The cover insulating layer 156 may include silicon oxide.

A shield conductive layer 162 may be disposed on the plurality of bit lines 147 opposite to the plurality of channel patterns 106P, that is, below the plurality of bit lines 147. The shield conductive layer 162 may cover a bottom surface of the cover insulating layer 156 and fill spaces between the plurality of bit line structures 140. The cover insulating layer 156 may be located between the plurality of bit lines 147 and the shield conductive layer 162. The shield conductive layer 162 may prevent interference between the plurality of bit lines 147. A protective insulating layer 164 may cover a bottom surface of the shield conductive layer 162. For example, the shield conductive layer 162 may include a metal material. For example, the protective insulating layer 164 may include silicon nitride. The bit line 147, the cover insulating layer 156, and the shield conductive layer 162 may include the bit line BL, the cover insulating layer BLO, and the shield conductive layer SL, respectively, shown in FIG. 1.

A first bonding insulating layer 170 may cover a bottom surface of the protective insulating layer 164. For example, the first bonding insulating layer 170 may include silicon oxide or silicon carbonitride (SiCN).

The plurality of connection structures 180 may be disposed on the plurality of channel patterns 106P. The plurality of connection structures 180 may be surrounded by a first surrounding insulating layer 192 and a second surrounding insulating layer 194. Each of the plurality of connection structures 180 may include a conductive material, for example, a doped semiconductor material, metal, conductive metal nitride, conductive metal carbonitride, conductive metal carbide, metal silicide, conductive metal oxynitride, conductive metal oxide, and two-dimensional (2D) material, but the embodiment is not limited thereto. In some embodiments, the plurality of connection structures 180 may be formed by implanting n-type impurities into upper portions of the plurality of channel patterns 106P.

Each of the plurality of connection structures 180 may include a lower connection structure BC and an upper connection structure LP on the lower connection structure BC. In some embodiments, the lower connection structure BC and the upper connection structure LP corresponding to each other may be aligned with each other in the vertical direction (Z direction). In some embodiments, the lower connection structure BC and the upper connection structure LP corresponding to each other are not aligned with each other in the vertical direction (Z direction), but the upper connection structure LP may be shifted in a horizontal direction from the lower connection structure BC corresponding thereto. The lower connection structure BC may have a stack structure of a first semiconductor layer 182 and a second semiconductor layer 184. The first semiconductor layer 182 may be in contact with an upper surface of the channel pattern 106P. In some embodiments, the first semiconductor layer 182 may include a single crystalline semiconductor material and the second semiconductor layer 184 may include a polycrystalline semiconductor material. For example, the first semiconductor layer 182 may be epitaxially grown using the channel pattern 106P as a seed. For example, the first semiconductor layer 182 may include single crystalline silicon, and the second semiconductor layer 184 may include polysilicon. In some embodiments, the upper connection structure LP may have a stack structure of a silicide layer 186 and a metal plug 188. For example, silicide layer 186 may include WSiₓ, NiSiₓ, CoSiₓ, or NiPtSiₓ, and metal plug 188 may include W, Mo, Au, Cu, Al, Ni, or Co. For example, the first surrounding insulating layer 192 may include silicon oxide, and the second surrounding insulating layer 194 may include silicon nitride. In some embodiments, each of the plurality of connection structures 180 may include the lower connection structure BC but may not include the upper connection structure LP.

The plurality of lower electrodes 310 may be respectively and electrically connected to the plurality of connection structures 180. A second end (e.g. an upper end) of both ends of each of the plurality of channel patterns 106P in the vertical direction (Z direction) may be electrically connected to a corresponding one of the plurality of lower electrodes 310. For example, the second end of both ends of each of the plurality of channel patterns 106P in the vertical direction (Z direction) may be electrically connected to a corresponding one of the plurality of lower electrodes 310 via a corresponding one of the plurality of connection structures 180. Each of the plurality of connection structures 180 may include the lower connection structure BC and the upper connection structure LP on the lower connection structure BC. The lower connection structure BC may be oriented toward the channel pattern 106P and electrically connected to the channel pattern 106P and the upper connection structure LP may be oriented toward the lower electrode 310 and electrically connected to the lower electrode 310.

Each of the plurality of lower electrodes 310 may have a column shape, that is, a pillar shape of which the inside is filled so at to have a circular horizontal cross-section, but the embodiment is not limited thereto. In some embodiments, each of the plurality of lower electrodes 310 may have a cylindrical shape with a lower portion closed. In some embodiments, the plurality of lower electrodes 310 may be arranged in a zigzag pattern in the first horizontal direction (X direction) and/or the second horizontal direction (Y direction) to form a honeycomb shape. In some embodiments, the plurality of lower electrodes 310 may be arranged in a row in each of the first horizontal direction (X direction) and the second horizontal direction (Y direction) to form a matrix shape. The plurality of lower electrodes 310 may include, for example, impurity-doped silicon, metal, such as tungsten or copper, or a conductive metal compound, such as titanium nitride.

A plurality of support patterns 350 may be in contact with sidewalls of the plurality of lower electrodes 310. The plurality of support patterns 350 may include a first support pattern 350a, a second support pattern 350b, a third support pattern 350c, and a fourth support pattern 350d, which are at different vertical levels so as to be spaced apart from each other in the vertical direction (Z direction), but the embodiment is not limited thereto. For example, the plurality of support patterns 350 may include two, three, or five or more support patterns, which are at different vertical levels and spaced apart from each other in the vertical direction (Z direction). The second support pattern 350b may be at a higher vertical level than the first support pattern 350a, the third support pattern 350c may be at a higher vertical level than the second support pattern 350b, and the fourth support pattern 350d may be at a higher vertical level than the third support pattern 350c. In some embodiments, an upper surface of an uppermost support pattern among the plurality of support patterns 350, for example, an upper surface of the fourth support pattern 350d may be at the same vertical level as an uppermost end of the plurality of lower electrodes 310, but the embodiment is not limited thereto. In some embodiments, the uppermost end of the plurality of lower electrodes 310 may protrude upward from the upper surface of the fourth support pattern 350d. For example, the upper surface of the fourth support pattern 350d may be at a lower vertical level than the uppermost end of the plurality of lower electrodes 310. Each of the plurality of support patterns 350 may include any one of a silicon nitride (SiN) film, silicon carbonitride (SiCN) film, N-rich silicon nitride (N-rich SiN) film, and Si-rich silicon nitride (Si-rich SiN) film, but the embodiment is not limited thereto.

In some embodiments, the lower electrode 310 may extend from a lower surface to an upper surface of the lower electrode 310 with a constant horizontal width. For example, the lower electrode 310 may extend with a first constant horizontal width between the lower surface of the lower electrode 310 and a lower surface of a lowermost support pattern 350 among the plurality of support patterns 350, for example, the first support pattern 350a, may extend with a second constant horizontal width between an upper surface of a support pattern 350 at a lower level (e.g. 350a) and a lower surface of a support pattern 350 at a higher level (e.g. 350b), the support pattern 350 at the lower level and the support pattern 350 at the higher level being two support patterns 350 adjacent to each other in the vertical direction (Z direction) among the plurality of support patterns 350. In some embodiments, the first constant horizontal width may be the same as the second constant horizontal width. In some other embodiments, the first constant horizontal width may be different from the second constant horizontal width. For example, an upper portion of the lower electrode 310 may have a greater horizontal width than that of a lower portion of the lower electrode 310. Also, the lower electrode 310 may extend with a third constant horizontal width between the lower surface of the lower electrode 310 and an upper surface of the lowermost support pattern 350 among the plurality of support patterns 350, for example, the first support pattern 350a, and may extend with a fourth constant horizontal width between upper surfaces of two support patterns 350 adjacent to each other in the vertical direction (Z direction) among the plurality of support patterns 350. In some embodiments, the third constant horizontal width may be the same as the fourth constant horizontal width. In some other embodiments, the third constant horizontal width may be different from the fourth constant horizontal width. For example, the upper portion of the lower electrode 310 may have a greater horizontal width than that of the lower portion of the lower electrode 310.

The capacitor dielectric layer 320 may conformally cover surfaces of the plurality of lower electrodes 310 and surfaces of the plurality of support patterns 350. In some embodiments, the capacitor dielectric layer 320 may be formed integrally so as to cover the plurality of lower electrodes 310 and the plurality of support patterns 350 within a certain region. Capacitor dielectric layer 320 may be, for example, TaO, TaAlO, TaON, AlO, AlSiO, HfO, HfSiO, ZrO, ZrSiO, TiO, TiAlO, BST ((Ba, Sr)TiO), STO (SrTiO), BTO (BaTiO), PZT ((Pb, Zr, Ti)O), (Pb, La)(Zr, Ti)O, Ba(Zr, Ti)O, Sr(Zr, Ti)O, or a combination thereof.

The upper electrode 330 may fill spaces between the plurality of lower electrodes 310 and the plurality of support patterns 350 and cover the capacitor dielectric layer 320. The upper electrode 330 may include, for example, W, Ru, RuO, Pt, PtO, Ir, IrO, SRO (SrRuO), BSRO ((Ba,Sr)RuO), CRO (CaRuO), BaRuO, La(Sr, Co)O, etc. In some embodiments, the upper electrode 330 may include a metal material. For example, the upper electrode 330 may include W. In some embodiments, the upper electrode 330 may further include at least one of a doped semiconductor material layer and an interface layer in addition to the metal material and may have a stack structure thereof. The doped semiconductor material layer may include, for example, at least one of doped polysilicon and doped polycrystalline silicon germanium (poly SiGe). The interface layer may include, for example, at least one of metal oxide, metal nitride, metal carbide, and metal silicide.

The peripheral circuit structure PS may include a circuit board 202 having an active region AC defined by a circuit device isolation film 204, a circuit gate structure 210 located on the active region AC of the circuit board 202, an inter-wiring insulating layer 220 covering the circuit gate structure 210 on the circuit board 202, and a wiring structure 230 surrounded by the inter-wiring insulating layer 220 and electrically connected to the active region AC and/or the circuit gate structure 210.

The circuit board 202 may include, for example, a semiconductor material, such as a group IV semiconductor material, a group III-V semiconductor material, a group II-VI semiconductor material, and a group II-VI oxide semiconductor material. The group IV semiconductor material may include, for example, silicon (Si), germanium (Ge), or silicon-germanium (Si-Ge). The group III-V semiconductor material may include, for example, gallium arsenide (GaAs), indium phosphide (InP), gallium phosphide (GaP), indium arsenide (InAs), indium antimonide (InSb), or indium gallium arsenide (InGaAs). The group II-VI semiconductor material may include, for example, zinc telluride (ZnTe), or cadmium sulfide (CdS). The circuit board 202 may include a bulk wafer or epitaxial layer. The circuit board 202 may be provided as a bulk wafer or epitaxial layer. In some embodiments, the circuit board 202 may include a silicon-on-insulator (SOI) substrate or a germanium-on-insulator (GeOI) substrate.

The circuit gate structure 210 may include a circuit gate electrode 214 on the active region AC, a circuit gate insulating layer 212 between the active region AC and the circuit gate electrode 214, a circuit gate capping layer 216 covering the circuit gate electrode 214 (e.g., an upper surface of the circuit gate electrode 214), and a circuit gate spacer 218 covering side surfaces of the circuit gate insulating layer 212, side surfaces of the circuit gate electrode 214, and side surfaces of the circuit gate capping layer 216. The active region AC and the circuit gate structure 210 may form a plurality of peripheral circuits.

The wiring structure 230 may include a circuit wiring line and a circuit wiring contact. The wiring structure 230 may include a conductive material, such as copper (Cu), aluminum (Al), tungsten (W), silver (Ag), gold (Au), and/or a combination thereof. The inter-wiring insulating layer 220 may include an insulating material containing silicon oxide, silicon nitride, a low-k material, or a combination thereof. The low-k material may have a lower dielectric constant than silicon oxide and include, for example, phosphosilicate glass (PSG), borophosphosilicate glass (BPSG), fluorosilicate glass (FSG), organosilicate glass (OSG), spin-on-glass (SOG), spin-on-polymer, or a combination thereof. In some embodiments, the inter-wiring insulating layer 220 may include a ultra low-k (ULK) film having an ultra-low dielectric constant K of about 2.2 to about 2.4. The ULK film may include SiOC or SiCOH.

A second bonding insulating layer 270 may cover the inter-wiring insulating layer 220 and the wiring structure 230. The second bonding insulating layer 270 may include silicon oxide or silicon carbonitride (SiCN). The second bonding insulating layer 270 and the first bonding insulating layer 170 may be bonded to each other while forming a covalent bond.

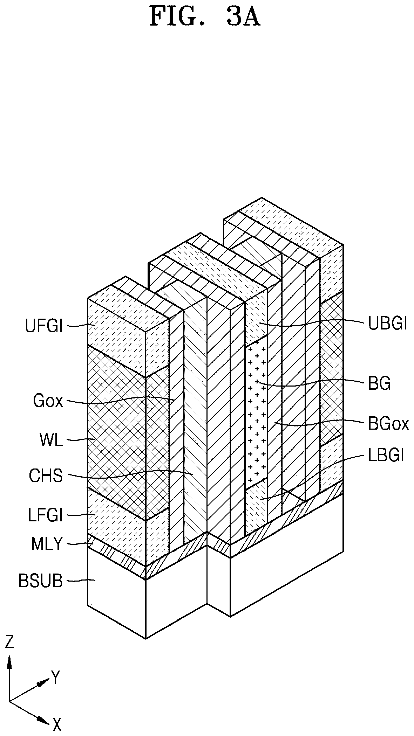

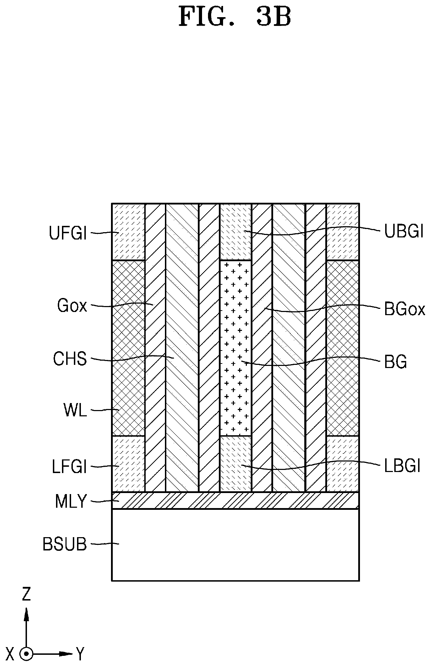

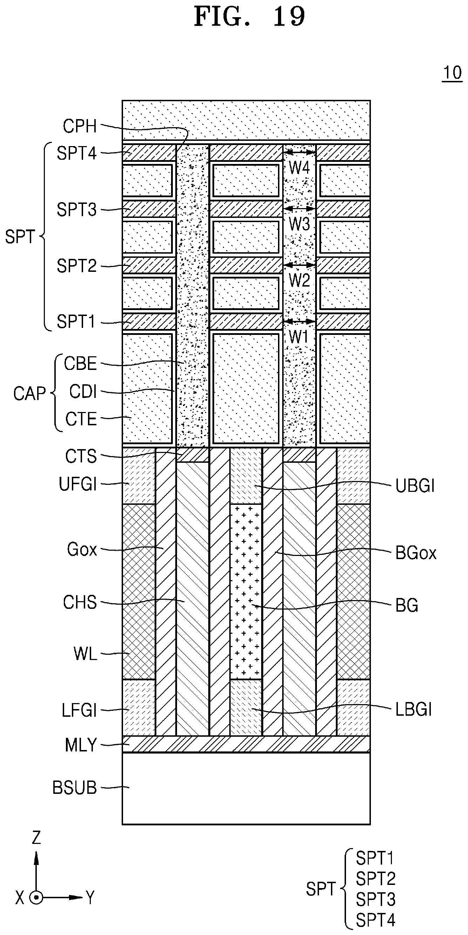

FIGS. 3A to 18 are perspective views and cross-sectional views illustrating a method of manufacturing a semiconductor memory device according to one or more example embodiments and FIG. 19 is a cross-sectional view showing the semiconductor memory device according to one or more example embodiments. Specifically, FIGS. 3A, 4A, 5A, and 6A are perspective views illustrating the method of manufacturing the semiconductor memory device according to one or more example embodiments and FIGS. 3B, 4B, 5B, 6B, and FIGS. 7 to 18 are cross-sectional views illustrating the method of manufacturing the semiconductor memory device according to one or more example embodiments.

Referring to FGIS. 3A and 3B, a base substrate BSUB, a middle layer MLY on the base substrate BSUB, and a channel structure CHS, a word line WL, and a back gate line BG on the middle layer MLY may be formed. Each of the word line WL and the back gate line BG may extend in a first horizontal direction (X direction). The channel structure CHS may extend in a vertical direction (Z direction) between the word line WL and the back gate line BG, which are adjacent in a second horizontal direction (Y direction). The gate insulating layer Gox may be located between the channel structure CHS and the word line WL and the back gate insulating layer BGox may be located between the channel structure CHS and the back gate line BG. In some embodiments, a first upper insulating layer UFGI and a first lower insulating layer LFGI may be disposed above the word line WL and disposed below the word line WL, respectively. In some embodiments, a second upper insulating layer UBGI and a second lower insulating layer LBGI may be disposed above the back gate line BG and disposed below the back gate line BG, respectively.

The base substrate BSUB may include the circuit board 202 shown in FIGS. 2A to 2D. Also, the middle layer MLY may include the components arranged between the plurality of channel patterns 106P and the circuit board 202 shown in FIGS. 2A to 2D. The channel structure CHS may include the channel pattern 106P and the connection structure 180 shown in FIGS. 2A to 2D. The word line WL may include the word line 134 shown in FIGS. 2A to 2D and the gate insulating layer Gox may include the gate insulating layer 132 shown in FIGS. 2A to 2D. The first upper insulating layer UFGI may include the buried capping layer 172 shown in FIGS. 2A to 2D and the first lower insulating layer LFGI may include the gate capping layer 138 shown in FIGS. 2A to 2D. The back gate line BG may include the back gate line 116 shown in FIGS. 2A to 2D and the back gate insulating layer BGox may include the back gate insulating layer 114 shown in FIGS. 2A to 2D. The second upper insulating layer UBGI may include the base insulating structure 113 shown in FIGS. 2A to 2D and the second lower insulating layer LBGI may include the back gate capping layer 118 shown in FIGS. 2A to 2D. In some embodiments, each of the first upper insulating layer UFGI and the second upper insulating layer UBGI may further include the first surrounding insulating layer 192 and the second surrounding insulating layer 194 shown in FIGS. 2A to 2D.

The components of FIGS. 3A and 3B are illustrated by simplifying the components of FIGS. 2A to 2D. The shapes thereof are not limited to those shown in FIGS. 3A and 3B, and detailed descriptions thereof are omitted.

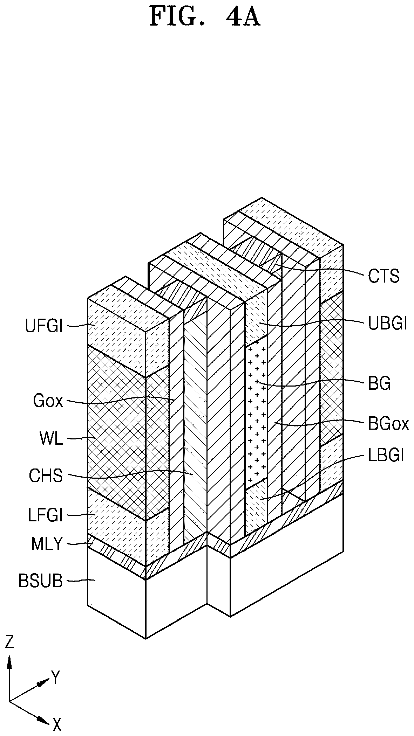

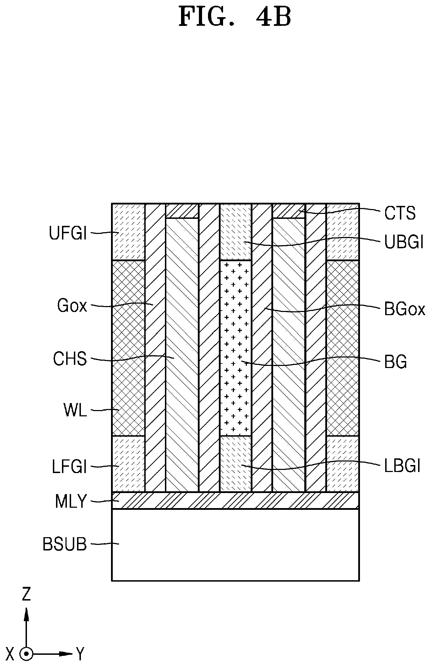

Referring to FIGS. 4A and 4B, a connection structure CTS may be formed on the channel structure CHS. In some embodiments, the connection structure CTS may be formed by implanting impurities into an upper portion of the channel structure CHS. For example, the connection structure CTS may be formed by implanting n-type impurities into the upper portion of the channel structure CHS. In some embodiments, the connection structure CTS may be formed separately on the upper surface of the channel structure CHS. The connection structure CTS may include the connection structure 180 shown in FIGS. 2A to 2D. In some embodiments, the connection structure CTS may include the lower connection structure BC shown in FIGS. 2A to 2D.

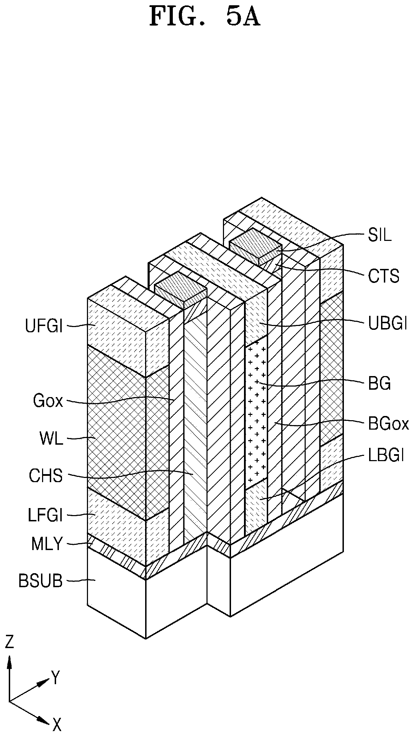

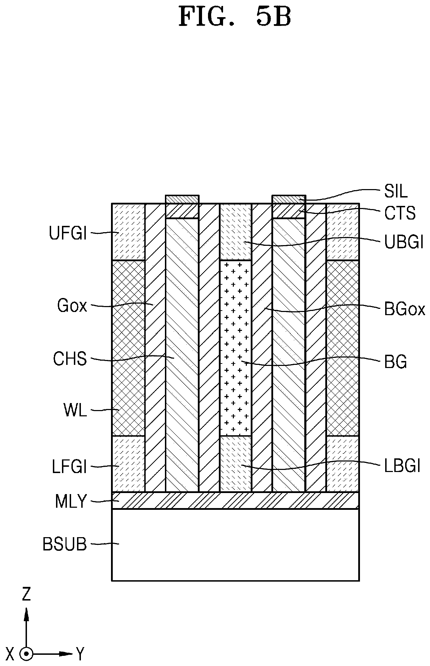

Referring to FIGS. 5A and 5B together, a silicide material layer SIL may be formed on the connection structure CTS. In some embodiments, the silicide material layer SIL may be formed by forming a metal material layer on the connection structure CTS and then performing a silicidation process on the metal material layer. The metal material layer may include Au, Al, Ag, Ni, Zn, Ti, Pd, W, or a transition metal, and the silicide material layer SIL may include an alloy of one or more metal materials, such as Au, Al, Ag, Ni, Zn, Ti, Pd, W, and a transition metal, and one or more semiconductor materials, such as Si and SiGe. The silicide material layer SIL may include an alloy of a semiconductor material and metal that may include a eutectic composition. A eutectic composition may be a composition that has a melting point that is lower than the melting points of each of its constituent materials. For instance, a eutectic composition of an alloy of a semiconductor material and a metal may have a lower melting point than the melting point of the semiconductor material and the melting point of the metal. When comparing the melting point of various substances for the purposes of assessing eutectic characteristics, the same pressure (e.g. 1 atm of pressure) may be used.

The silicide material layer SIL may include a silicide (AuSiₓ) of Au and Si. The silicide material layer SIL may have a composition of 19 atom % ± 5 % Au and 81 atom % ± 10 % Si. For example, if the silicide material layer SIL includes silicide (AlSiₓ) of Al and Si, the silicide material layer SIL may have a composition of 12 atom % ± 5 % Al and 88 atom % ± 10 % Si. For example, if the silicide material layer SIL includes silicide of Ag and Si (AgSiₓ), the silicide material layer SIL may have a composition of 11 atom % ± 5 % Ag and 89 atom % ± 10 % Si. After forming the silicide material layer SIL, the remaining metal material layer may be removed.

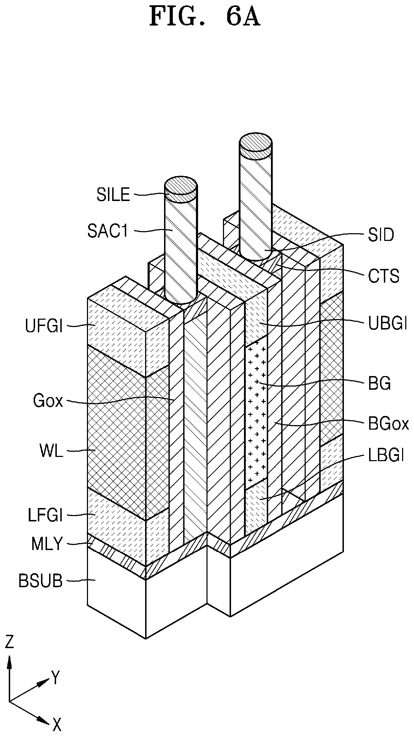

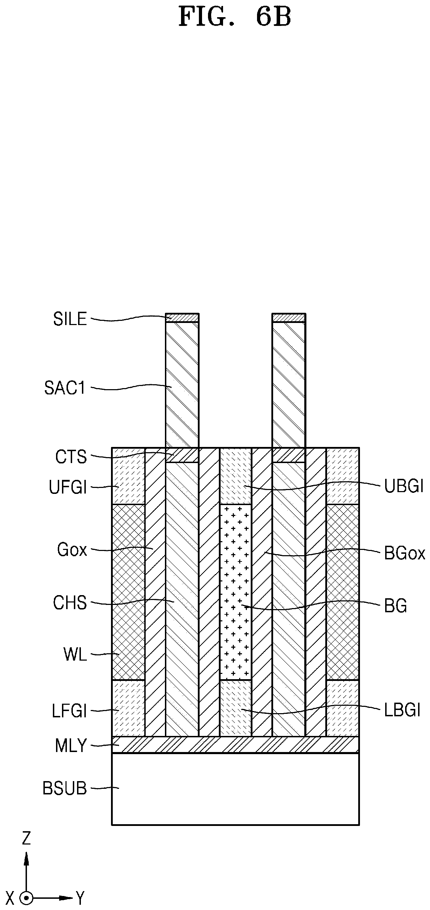

Referring to FIGS. 6A and 6B together, metal-induced crystallization (MIC) may be performed by heating the channel structure CHS and the silicide material layer SIL and injecting semiconductor material precursors thereinto. Consequently, a first sub-sacrificial semiconductor layer SAC1 may be formed. The silicide material layer SIL shown in FIGS. 5A and 5B may be converted into an induced silicide material layer SILE having a circular planar shape and a hemispherical shape due to surface tension. For instance, the silicide material layer SILE may have a hemispherical, or domed, shape. The silicide material layer SILE may have a circular cross-section (taken along the horizontal plane). The semiconductor material precursor may include a gas containing one or more semiconductor elements, such as a gas containing Ge or a gas containing Si and Ge. The first sub-sacrificial semiconductor layer SAC1 may have a cylindrical shape with a constant horizontal width based on the MIC. The first sub-sacrificial semiconductor layer SAC1 may include Ge or SiGe. For example, in the first sub-sacrificial semiconductor layer SAC1, atom % of Ge may be about 1 % to about 100 % and atom % of Si may be about 0 % to about 99 %.

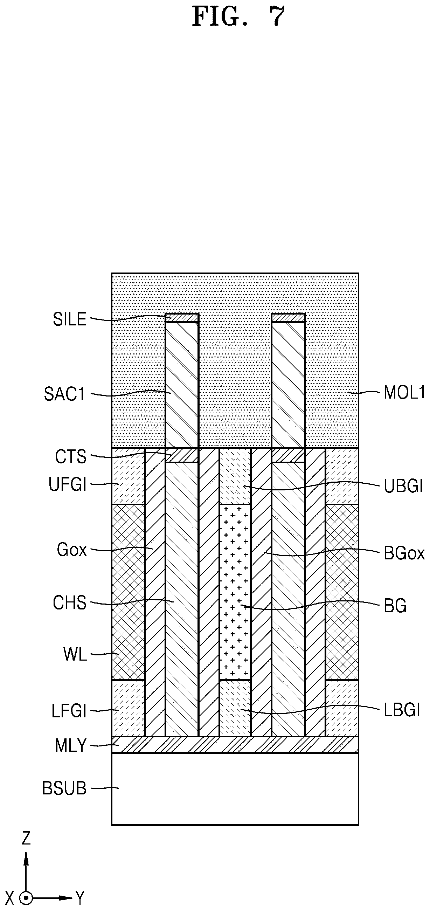

Referring to FIG. 7, a first sub-mold layer MOL1 may be formed, which covers the first sub-sacrificial semiconductor layer SAC1 and the induced silicide material layer SILE. The first sub-mold layer MOL1 may cover a side surface of each of the first sub-sacrificial semiconductor layer SAC1 and the induced silicide material layer SILE and cover an upper surface of the induced silicide material layer SILE. The first sub-mold layer MOL1 may include a material having an etch selectivity with respect to the first sub-sacrificial semiconductor layer SAC1 and the induced silicide material layer SILE. For example, the first sub-mold layer MOL1 may include a spin-on hard mask (SOH) material or a semiconductor oxide layer. For example, the semiconductor oxide layer may include oxide, such as tetraethyl orthosilicate (TEOS) oxide or high density plasma (HDP) oxide.

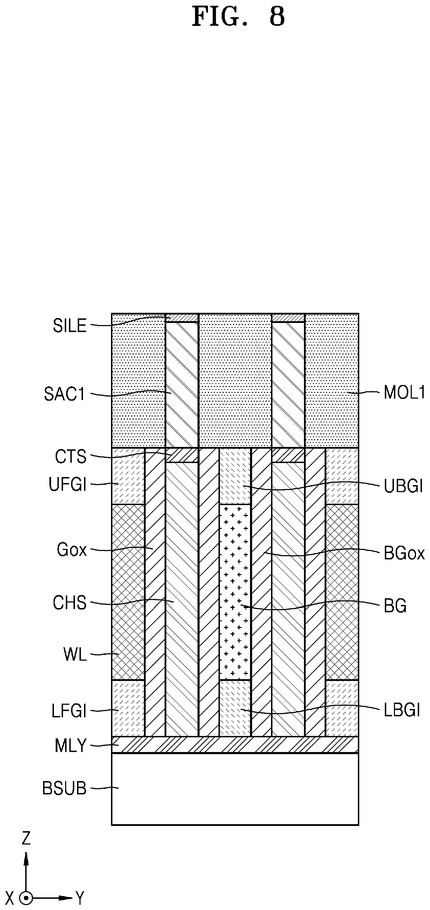

Referring to FIGS. 7 and 8 together, an upper portion of the first sub-mold layer MOL1 may be removed to expose the induced silicide material layer SILE. For example, the upper portion of the first sub-mold layer MOL1 may be removed by performing a chemical mechanical polishing (CMP) process in which the induced silicide material layer SILE is used as an etch stop film.

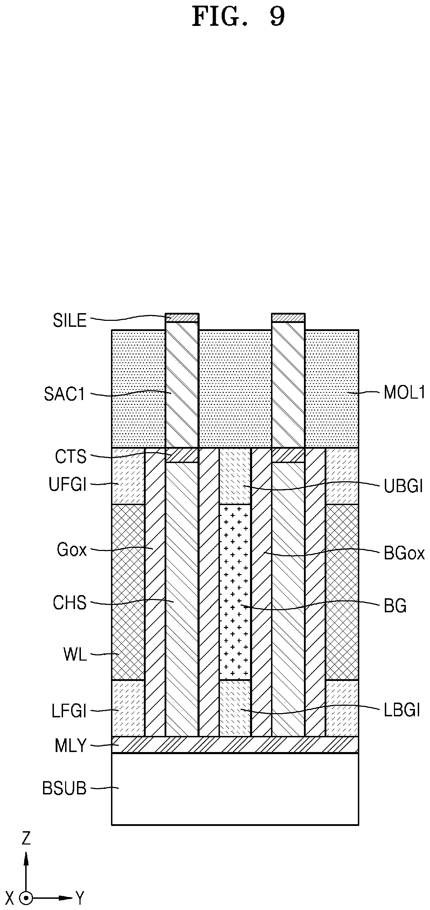

Referring to FIGS. 8 and 9 together, the upper portion of the first sub-mold layer MOL1 may be removed so that an upper portion of the first sub-sacrificial semiconductor layer SAC1 is exposed. The upper portion of the first sub-mold layer MOL1 may be removed by performing an etching process using the etch selectivity with respect to the first sub-sacrificial semiconductor layer SAC1 and the induced silicide material layer SILE.

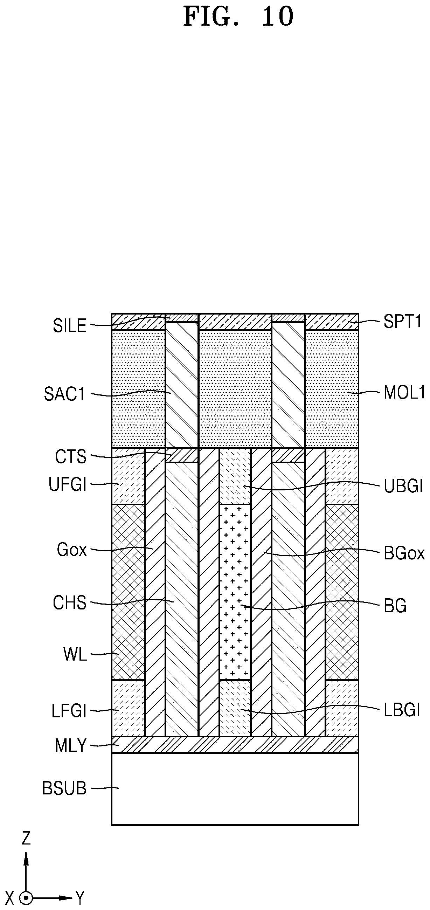

Referring to FIG. 10, a first support pattern SPT1 covering a side surface of an upper portion of the first sub-sacrificial semiconductor layer SAC1 and a side surface of the induced silicide material layer SILE may be formed on the first sub-mold layer MOL1. The first support pattern SPT1 may include the first support pattern 350a shown in FIGS. 2A to 2D. A first preliminary support material layer covering the first sub-sacrificial semiconductor layer SAC1 and the induced silicide material layer SILE may be formed on the first sub-mold layer MOL1. Subsequently, an upper portion of the first preliminary support material layer may be removed by performing a CMP process using the induced silicide material layer SILE as an etch stop film. Consequently, the first support pattern SPT1 may be formed.

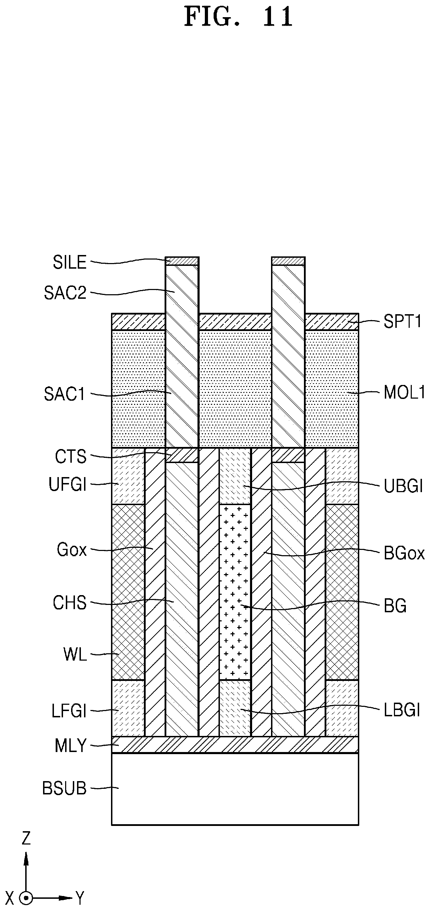

Referring to FIGS. 10 and 11 together, the MIC may be performed by heating the induced silicide material layer SILE and injecting semiconductor material precursors into the induced silicide material layer SILE, and thus, a second sub-sacrificial semiconductor layer SAC2 may be formed on the first sub-sacrificial semiconductor layer SAC1. The second sub-sacrificial semiconductor layer SAC2 may have a cylindrical shape with a constant horizontal width by the MIC. The second sub-sacrificial semiconductor layer SAC2 may include Ge or SiGe. The second sub-sacrificial semiconductor layer SAC2 may have the same horizontal width as the first sub-sacrificial semiconductor layer SAC1 and may be aligned with the first sub-sacrificial semiconductor layer SAC1 in the vertical direction (Z direction). The second sub-sacrificial semiconductor layer SAC2 may be formed integrally (or as one body) with the first sub-sacrificial semiconductor layer SAC1.

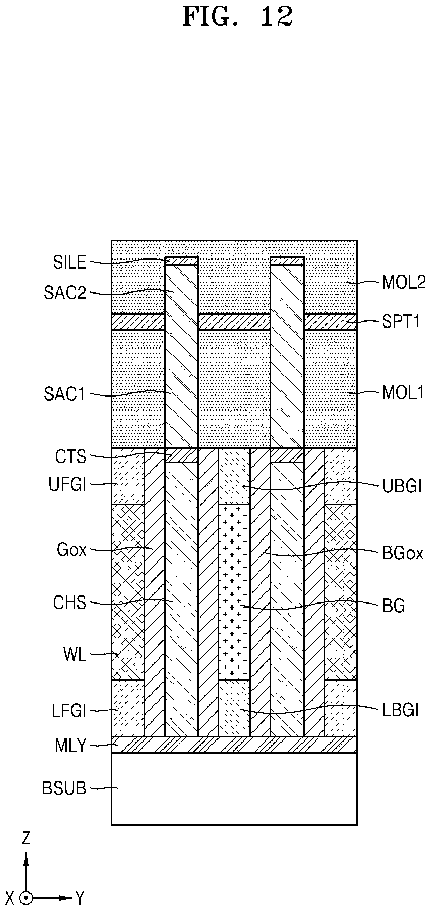

Referring to FIG. 12, a second sub-mold layer MOL2 may be formed, which covers the second sub-sacrificial semiconductor layer SAC2 and the induced silicide material layer SILE. For example, the second sub-mold layer MOL2 may include the same material as the first sub-mold layer MOL1.

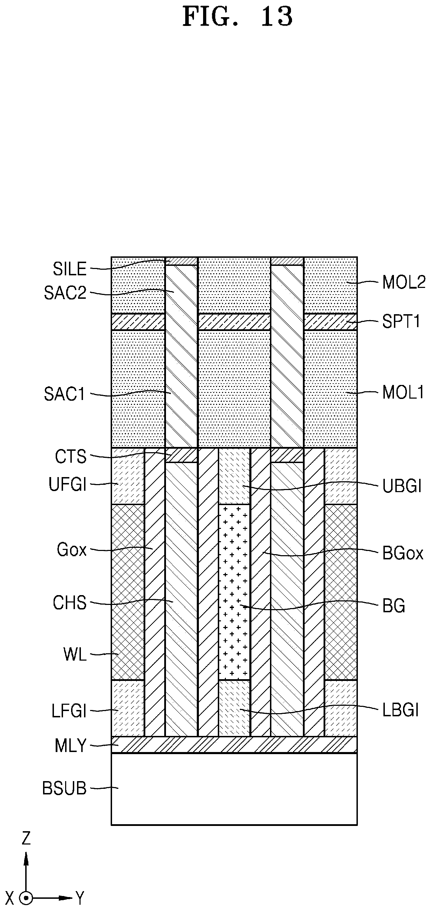

Referring to FIGS. 12 and 13 together, an upper portion of the second sub-mold layer MOL2 may be removed to expose the induced silicide material layer SILE.

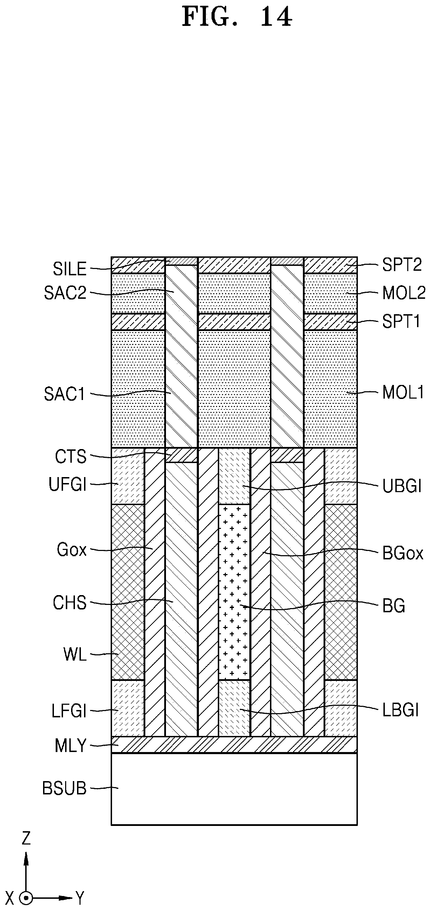

Referring to FIGS. 13 and 14 together, an upper portion of the second sub-mold layer MOL2 may be removed such that an upper portion of the second sub-sacrificial semiconductor layer SAC2 is exposed. Subsequently, a second support pattern SPT2 covering the side surface of the upper portion of the second sub-sacrificial semiconductor layer SAC2 and the side surface of the induced silicide material layer SILE may be formed on the second sub-mold layer MOL2. The second support pattern SPT2 may include the second support pattern 350b shown in FIGS. 2A to 2D.

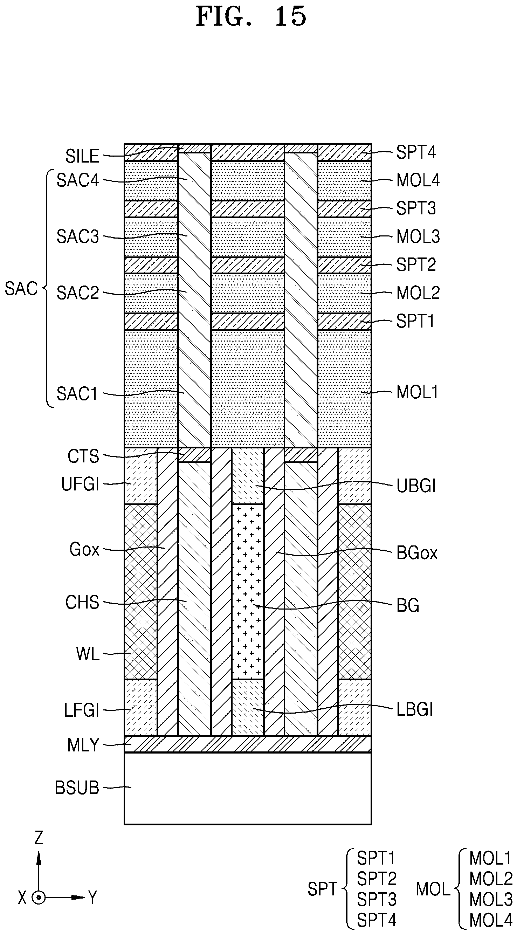

Referring to FIG. 15, based on the descriptions above with reference to FIGS. 6A to 14, there may be formed a third sub-sacrificial semiconductor layer SAC3 on the second sub-sacrificial semiconductor layer SAC2, a third sub-mold layer MOL3 surrounding the third sub-sacrificial semiconductor layer SAC3, a third support pattern SPT3 covering a side surface of an upper portion of the third sub-sacrificial semiconductor layer SAC3, a fourth sub-sacrificial semiconductor layer SAC4 on the third sub-sacrificial semiconductor layer SAC3, a fourth sub-mold layer MOL4 surrounding the fourth sub-sacrificial semiconductor layer SAC4, and a fourth support pattern SPT4 covering a side surface of each of an upper portion of the fourth sub-sacrificial semiconductor layer SAC4 and the induced silicide material layer SILE. The third support pattern SPT3 may include the third support pattern 350c shown in FIGS. 2A to 2D and the fourth support pattern SPT4 may include the fourth support pattern 350d shown in FIGS. 2A to 2D.

The sacrificial semiconductor layer SAC may include the first sub-sacrificial semiconductor layer SAC1, the second sub-sacrificial semiconductor layer SAC2, the third sub-sacrificial semiconductor layer SAC3, and the fourth sub-sacrificial semiconductor layer SAC4. The first sub-sacrificial semiconductor layer SAC1, the second sub-sacrificial semiconductor layer SAC2, the third sub-sacrificial semiconductor layer SAC3, and the fourth sub-sacrificial semiconductor layer SAC4 may be parts of the sacrificial semiconductor layer SAC arranged sequentially from the bottom to the top of the sacrificial semiconductor layer SAC. A plurality of support patterns SPT are shown as including the first support pattern SPT1, the second support pattern SPT2, the third support pattern SPT3, and the fourth support pattern SPT4, and a plurality of mold layers MOL are shown as including the first sub-mold layer MOL1, the second sub-mold layer MOL2, the third sub-mold layer MOL3, and the fourth sub-mold layer MOL4. However, the embodiment is not limited thereto. For example, the plurality of support patterns SPT may include two, three, or five or more support patterns and the plurality of mold layers MOL may include two, three, or five or more mold layers. For example, each of the plurality of mold layers MOL may include the same material.

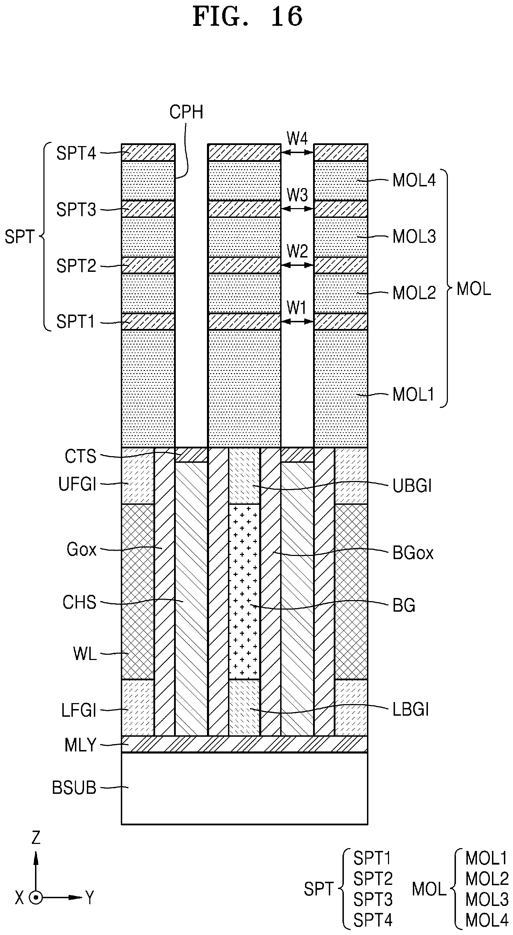

Referring to FIGS. 15 and 16 together, the induced silicide material layer SILE and the sacrificial semiconductor layer SAC may be removed to form a capacitor hole CPH that passes through the plurality of mold layers MOL and the plurality of support patterns SPT. In the capacitor hole CPH, regions passing through the first support pattern SPT1, the second support pattern SPT2, the third support pattern SPT3, and the fourth support pattern SPT4 may be referred to as a first support hole, a second support hole, a third support hole, and a fourth support hole, respectively. The connection structure CTS may be exposed through the bottom surface of the capacitor hole CPH. The first support hole, the second support hole, the third support hole, and the fourth support hole may have a first horizontal width W1, a second horizontal width W2, a third horizontal width W3, and a fourth horizontal width W4, respectively. In some embodiments, the first horizontal width W1, the second horizontal width W2, the third horizontal width W3, and the fourth horizontal width W4 may have the same value. In some embodiments, the first horizontal width W1, the second horizontal width W2, the third horizontal width W3, and the fourth horizontal width W4 may have the same value as the horizontal width of the channel structure CHS and the horizontal width of the connection structure CTS. In some embodiments, the capacitor hole CPH may have a constant horizontal width from a lowermost end to an uppermost end of the capacitor hole CPH.

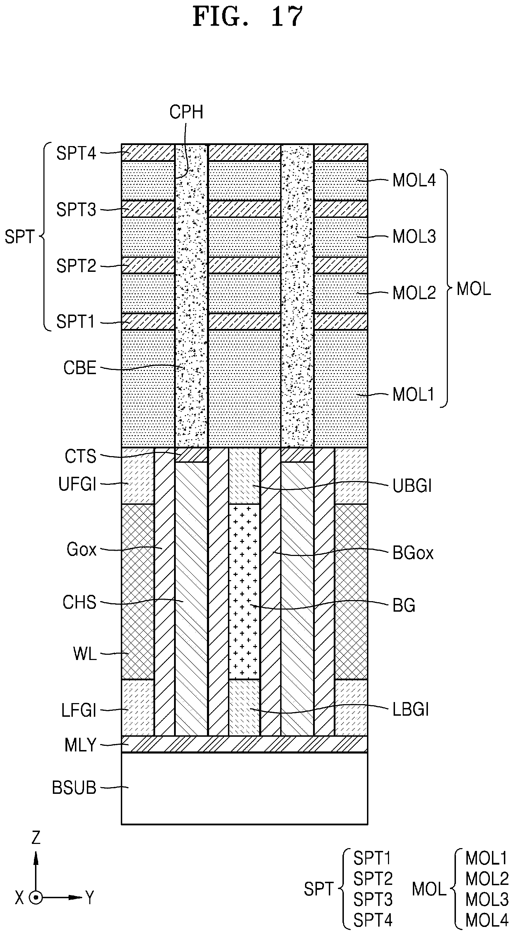

Referring to FIG. 17, a lower electrode CBE may be formed so as to fill the capacitor hole CPH. The lower electrode CBE may pass through the plurality of mold layers MOL and the plurality of support patterns SPT. The plurality of support patterns SPT may be in contact with sidewalls of the lower electrode CBE. The lower electrode CBE may fill all of the first support hole of the first support pattern SPT1, the second support hole of the second support pattern SPT2, the third support hole of the third support pattern SPT3, and the fourth support hole of the fourth support pattern SPT4.

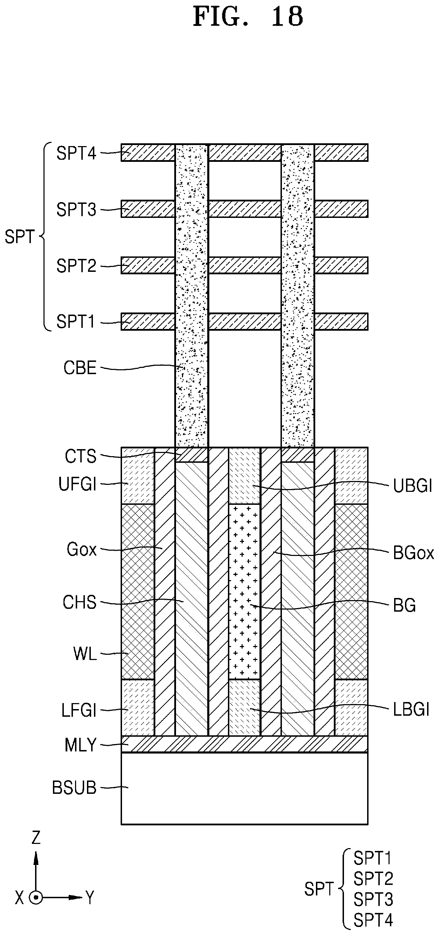

Referring to FIGS. 17 and 18 together, the plurality of mold layers MOL may be removed.

Referring to FIG. 19, a capacitor dielectric layer CDI and an upper electrode CTE may be formed. The capacitor dielectric layer CDI may cover surfaces of a plurality of lower electrodes CBE and surfaces of the plurality of support patterns SPT, and the upper electrode CTE may fill spaces between the plurality of lower electrodes CBE and the plurality of support patterns SPT and cover the capacitor dielectric layer CDI. Accordingly, a plurality of capacitor structures CAP including the plurality of lower electrodes CBE, the capacitor dielectric layer CDI, and the upper electrode CTE may be formed. Consequently, a semiconductor memory device 10 may be formed. The semiconductor memory device 10, a capacitor structure CAP, the lower electrode CBE, the capacitor dielectric layer CDI, and the upper electrode CTE may respectively include the semiconductor memory device 1, the capacitor structure 300, the lower electrode 310, the capacitor dielectric layer 320, and the upper electrode 330 shown in FIGS. 2A to 2D.

The lower electrode CBE may have a first horizontal width W1 in an area between a lower surface of the lower electrode CBE and an upper surface of the first support pattern SPT1 in the vertical direction (Z direction), a second horizontal width W2 in an area between the upper surface of the first support pattern SPT1 and an upper surface of the second support pattern SPT2 in the vertical direction (Z direction), a third horizontal width W3 in an area between the upper surface of the second support pattern SPT2 and an upper surface of the third support pattern SPT3 in the vertical direction (Z direction), and a fourth horizontal width W4 in an area between the upper surface of the third support pattern SPT3 and an upper surface of the fourth support pattern SPT4 in the vertical direction (Z direction). The first horizontal width W1, the second horizontal width W2, the third horizontal width W3, and the fourth horizontal width W4 may have the same value. The lower electrode CBE may have a constant horizontal width from a lowermost end to an uppermost end of the lower electrode CBE.

Referring together to FIGS. 3A to 19, the method of manufacturing the semiconductor memory device 10 according to one or more example embodiments of the inventive concept includes removing the sacrificial semiconductor layer SAC to form the capacitor hole CPH that is filled with the lower electrode CBE. The sacrificial semiconductor layer SAC may be formed by performing the MIC on the connection structure CTS. Also, even if the height of the lower electrode CBE filling the capacitor hole CPH increases, the connection structure CTS may be exposed through the bottom surface of the capacitor hole CPH because the capacitor hole CPH is formed by removing the sacrificial semiconductor layer SAC. Therefore, a not-open defect, in which the connection structure CTS is not exposed through the bottom surface of the capacitor hole CPH, may not occur, thereby securing the reliability of the semiconductor memory device.

Also, the sacrificial semiconductor layer SAC may be formed by performing the MIC and thus have a constant horizontal width from the lower surface to the upper surface of the sacrificial semiconductor layer SAC. Therefore, even if the horizontal width of the sacrificial semiconductor layer SAC is reduced, the height of the sacrificial semiconductor layer SAC may be increased, and the height of the lower electrode CBE may also be increased. Accordingly, the capacitance of the capacitor structure CAP of the semiconductor memory device 10 may be secured, and thus, the reliability of the semiconductor memory device 10 may be secured.

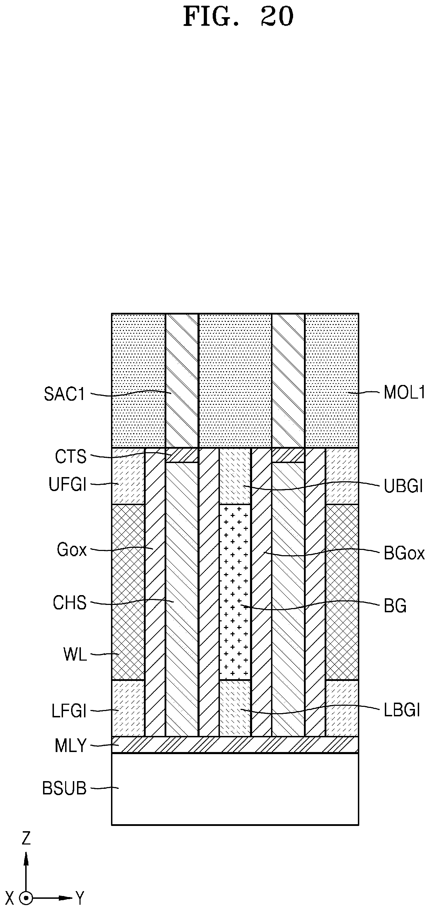

FIGS. 20 to 25 are cross-sectional views illustrating the method of manufacturing the semiconductor memory device according to one or more example embodiments. Specifically, FIGS. 20 to 25 are cross-sectional views showing operations after FIG. 8.

Referring to FIGS. 8 and 20 together, the upper portion of the first sub-mold layer MOL1 and the induced silicide material layer SILE may be removed. The upper portion of the first sub-mold layer MOL1 and the induced silicide material layer SILE may be removed by performing a CMP process in which the first sub-sacrificial semiconductor layer SAC1 is used as an etch stop film.

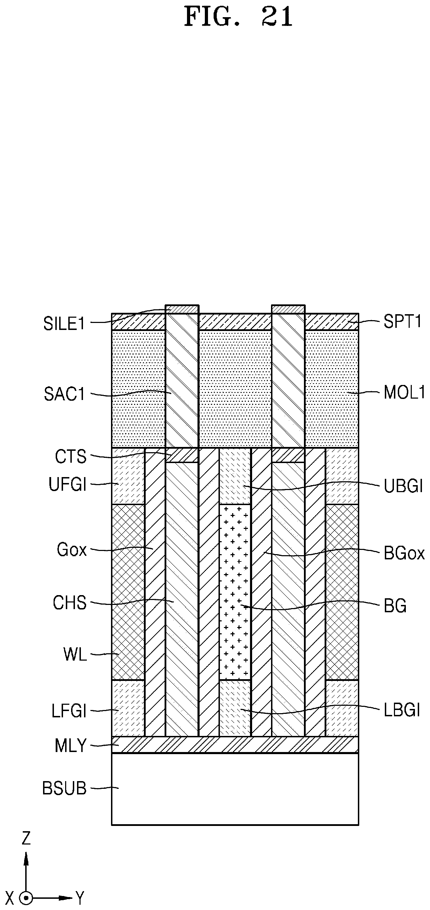

Referring to FIGS. 20 and 21 together, the upper portion of the first sub-mold layer MOL1 may be further removed so that an upper portion of the first sub-sacrificial semiconductor layer SAC1 is exposed. The upper portion of the first sub-mold layer MOL1 may be removed by performing an etching process using the etch selectivity with respect to the first sub-sacrificial semiconductor layer SAC1. Subsequently, the first support pattern SPT1 may be formed on the first sub-mold layer MOL1 so as to cover a side surface of an upper portion of the first sub-sacrificial semiconductor layer SAC1.

A first sub-induced silicide material layer SILE1 may be formed on the upper surface of the first sub-sacrificial semiconductor layer SAC1. The first sub-induced silicide material layer SILE1 may be generally similar to the induced silicide material layer SILE shown in FIG. 8, and thus, detailed descriptions thereof are omitted. When the MIC is performed after forming a silicide material layer on the upper surface of the first sub-sacrificial semiconductor layer SAC1, the silicide material layer may be converted into the first sub-induced silicide material layer SILE1.

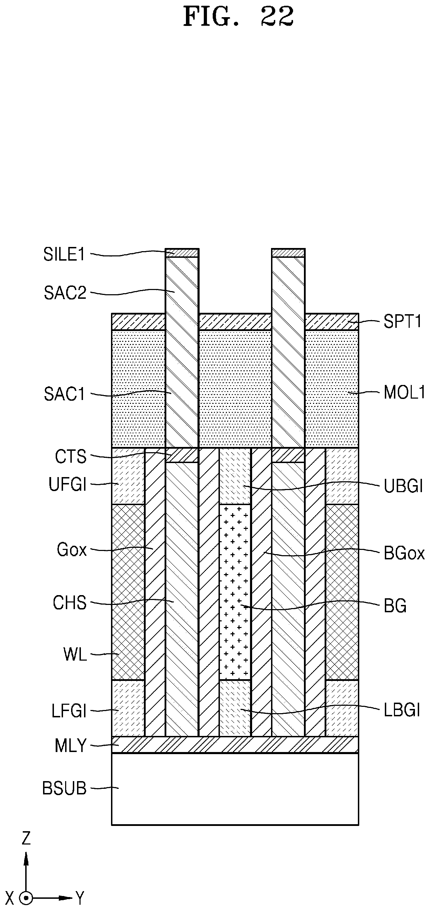

Referring to FIGS. 21 and 22 together, the MIC may be performed by heating the first sub-induced silicide material layer SILE1 and injecting semiconductor material precursors into the first sub-induced silicide material layer SILE1, and thus, the second sub-sacrificial semiconductor layer SAC2 may be formed on the first sub-sacrificial semiconductor layer SAC1.

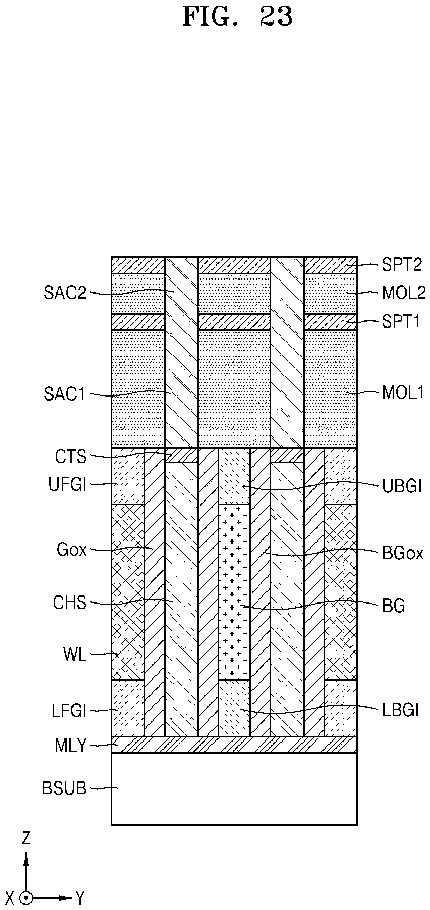

Referring to FIGS. 22 and 23 together, the second sub-mold layer MOL2 may be formed covering the second sub-sacrificial semiconductor layer SAC2 and the first sub-induced silicide material layer SILE1. Subsequently, an upper portion of the second sub-mold layer MOL2 and the first sub-induced silicide material layer SILE1 may be removed to expose an upper portion of the second sub-sacrificial semiconductor layer SAC2. Subsequently, the second support pattern SPT2 may be formed on the second sub-mold layer MOL2 so as to cover a side surface of an upper portion of the second sub-sacrificial semiconductor layer SAC2.

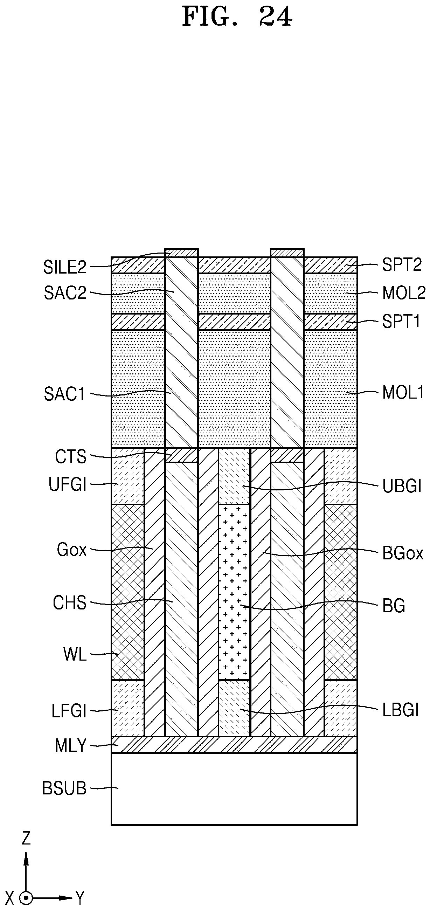

Referring to FIG. 24, a second sub-induced silicide material layer SILE2 may be formed on the upper surface of the second sub-sacrificial semiconductor layer SAC2. The second sub-induced silicide material layer SILE2 may be generally similar to the first sub-induced silicide material layer SILE1 shown in FIG. 22, and thus, detailed descriptions thereof are omitted.

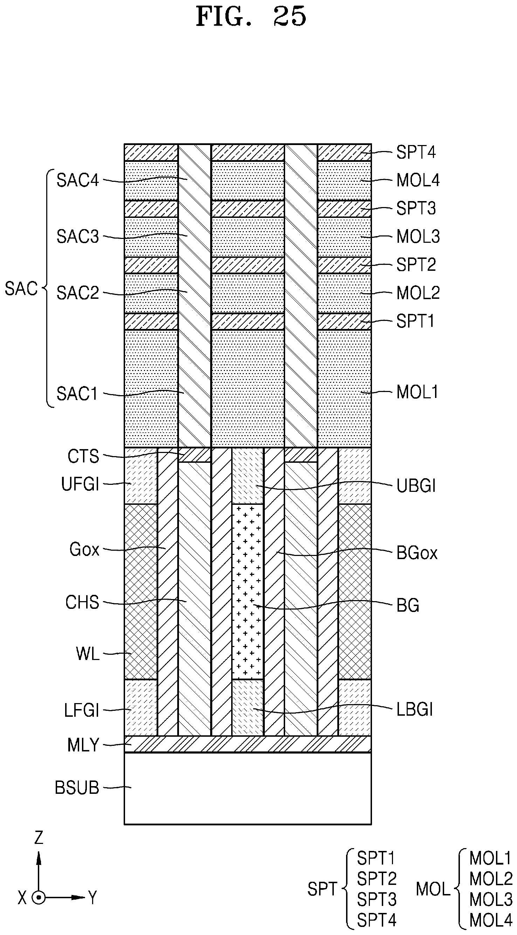

Referring to FIGS. 24 and 25 together, based on the descriptions above with reference to FIGS. 22 to 23, there may be formed the third sub-sacrificial semiconductor layer SAC3 on the second sub-sacrificial semiconductor layer SAC2, the third sub-mold layer MOL3 surrounding the third sub-sacrificial semiconductor layer SAC3, the third support pattern SPT3 covering a side surface of an upper portion of the third sub-sacrificial semiconductor layer SAC3, the fourth sub-sacrificial semiconductor layer SAC4 on the third sub-sacrificial semiconductor layer SAC3, the fourth sub-mold layer MOL4 surrounding the fourth sub-sacrificial semiconductor layer SAC4, and the fourth support pattern SPT4 covering a side surface of an upper portion of the fourth sub-sacrificial semiconductor layer SAC4. In order to form the fourth sub-sacrificial semiconductor layer SAC4, a third sub-induced silicide material layer similar to the first sub-induced silicide material layer SILE1 shown in FIG. 22 and the second sub-induced silicide material layer SILE2 shown in FIG. 24 may be formed. After the fourth sub-sacrificial semiconductor layer SAC4 is formed, the third sub-induced silicide material layer may be removed.

The induced silicide material layer SILE, the first sub-induced silicide material layer SILE1, the second sub-induced silicide material layer SILE2, and the third sub-induced silicide material layer may be referred to as a first induced silicide material layer, a second induced silicide material layer, a third induced silicide material layer, and a fourth induced silicide material layer, respectively. FIGS. 3A to 19 illustrate the method of forming each of the first sub-sacrificial semiconductor layer SAC1, the second sub-sacrificial semiconductor layer SAC2, the third sub-sacrificial semiconductor layer SAC3, and the fourth sub-sacrificial semiconductor layer SAC4, using the induced silicide material layer SILE. FIGS. 20 to 25 illustrate the method of respectively forming the first sub-sacrificial semiconductor layer SAC1, the second sub-sacrificial semiconductor layer SAC2, the third sub-sacrificial semiconductor layer SAC3, and the fourth sub-sacrificial semiconductor layer SAC4, using the first induced silicide material layer, the second induced silicide material layer, the third induced silicide material layer, and the fourth induced silicide material layer.

Subsequently, the sacrificial semiconductor layer SAC may be removed to form the capacitor hole CPH shown in FIG. 16. Accordingly, the semiconductor memory device 10 shown in FIGS. 17 to 19 may be formed.

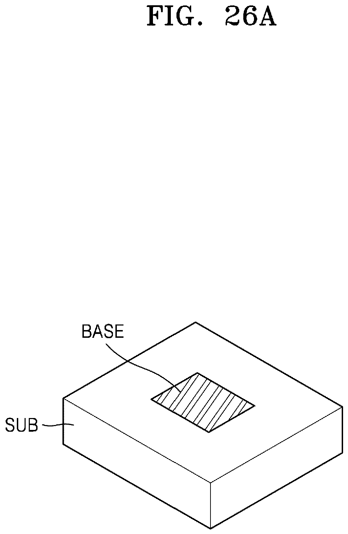

FIGS. 26A to 26E are conceptual diagrams illustrating a method of forming the sacrificial structure, which is used in the method of manufacturing the semiconductor memory device according to one or more example embodiments.

Referring to FIG. 26A, a substrate SUB having a base layer BASE may be prepared. The base layer BASE may correspond to the connection structure CTS on the channel structure CHS shown in FIGS. 4A and 4B.

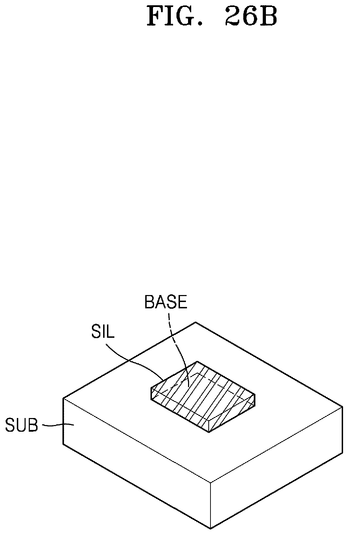

Referring to FIG. 26B, a silicide material layer SIL may be formed on the base layer BASE. In some embodiments, the silicide material layer SIL may have a horizontal shape (e.g. a cross-section) that is substantially the same as that of the base layer BASE.

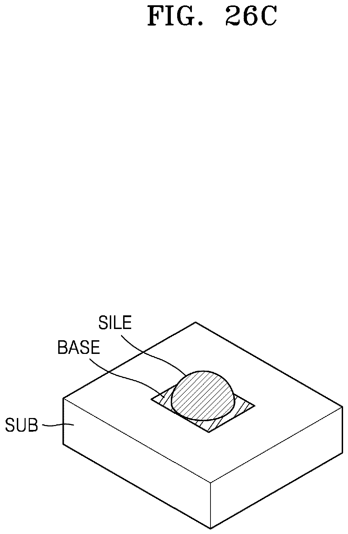

Referring to FIGS. 26B and 26C together, when heat is applied to the silicide material layer SIL, an induced silicide material layer SILE having a circular planar shape (e.g. a circular cross-section) and a hemispherical shape due to the surface tension may be formed.

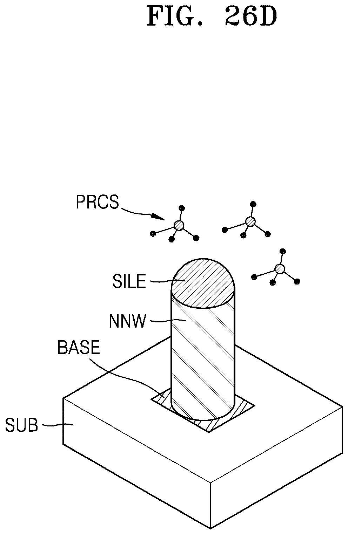

Referring to FIG. 26D, the MIC occurs when semiconductor material precursors PRCS are injected into the base layer BASE and the induced silicide material layer SILE. Accordingly, a nanowire NNW may be formed between the base layer BASE and the induced silicide material layer SILE. The nanowire NNW may have a planar shape that is substantially the same as that of the induced silicide material layer SILE. For example, the nanowire NNW may have a cylindrical shape having a constant horizontal width. For example, the horizontal width of the nanowire NNW may be substantially the same as the horizontal width of the induced silicide material layer SILE.

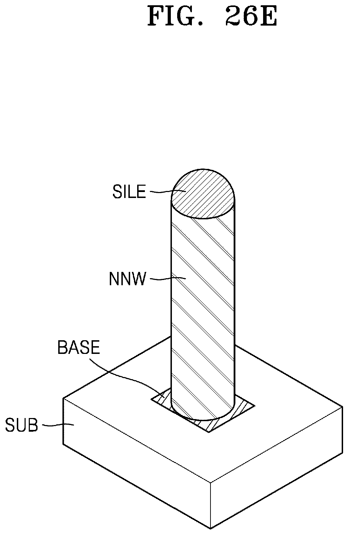

Referring to FIGS. 26D and 26E together, the MIC may continue to form the nanowire NNW having a desired height. The nanowire NNW may have a constant horizontal width from the lower surface to upper surface of the nanowire NNW. The nanowire NNW may correspond to the sacrificial semiconductor layer SAC shown in FIGS. 15 and 25.

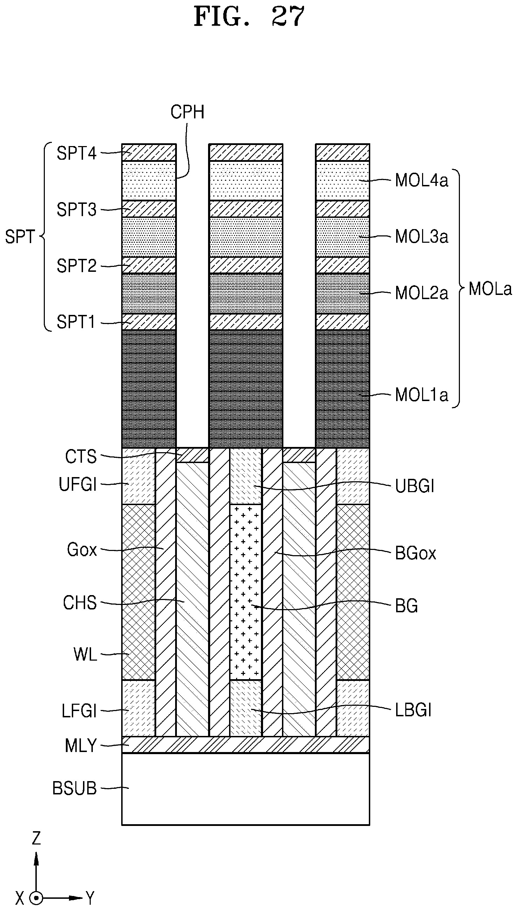

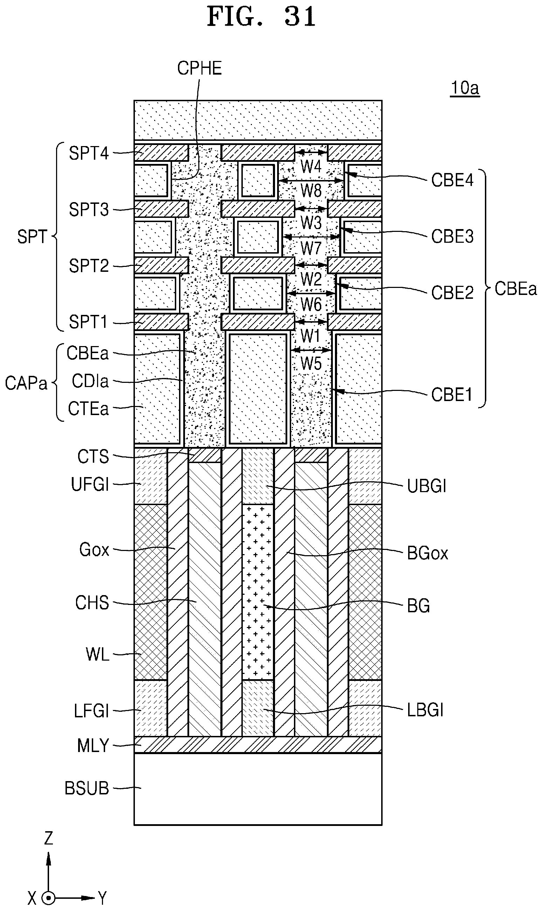

FIGS. 27 to 30 are cross-sectional views illustrating a method of manufacturing a semiconductor memory device according to one or more example embodiments and FIG. 31 is a cross-sectional view showing the semiconductor memory device according to one or more example embodiments.

Referring to FIG. 27, instead of the plurality of mold layers MOL including the first sub-mold layer MOL1, the second sub-mold layer MOL2, the third sub-mold layer MOL3, and the fourth sub-mold layer MOL4 shown in FIG. 16, a plurality of mold layers MOLa may be formed which include a first sub-mold layer MOL1a, a second sub-mold layer MOL2a, a third sub-mold layer MOL3a, and a fourth sub-mold layer MOL4a, and then a capacitor hole CPH may be formed which passes through the plurality of mold layers MOLa and a plurality of support patterns SPT.

The first sub-mold layer MOL1a, the second sub-mold layer MOL2a, the third sub-mold layer MOL3a, and the fourth sub-mold layer MOL4a may include similar materials, but etching rates thereof may be different from each other. In some embodiments, the fourth sub-mold layer MOL4a may have a higher (e.g. slightly higher) etching rate than the third sub-mold layer MOL3a, the third sub-mold layer MOL3a may have a higher (e.g. slightly higher) etching rate than the second sub-mold layer MOL2a, and the second sub-mold layer MOL2a may have a higher (e.g. slightly higher) etching rate than the first sub-mold layer MOL1a. For example, the first sub-mold layer MOL1a, the second sub-mold layer MOL2a, the third sub-mold layer MOL3a, and the fourth sub-mold layer MOL4a may include spin-on hard mask materials or semiconductor oxide layers but may have different etching rates due to different composition ratios for constituting the spin-on hard mask materials or different composition ratios for constituting the semiconductor oxide layers.

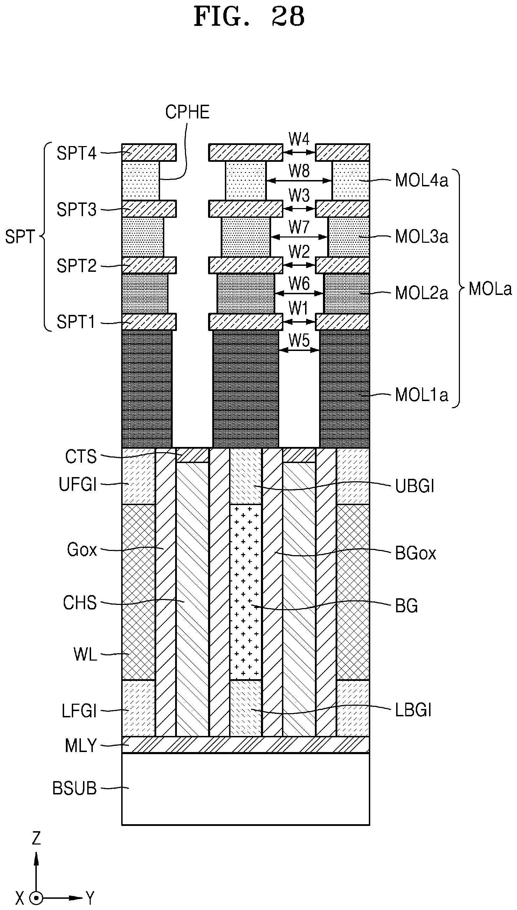

Referring to FIGS. 27 and 28 together, a portion of each of the first sub-mold layer MOL1a, the second sub-mold layer MOL2a, the third sub-mold layer MOL3a, and the fourth sub-mold layer MOL4a may be removed via the capacitor hole CPH. Consequently, an expanded capacitor hole CPHE may be formed. The expanded capacitor hole CPHE may also be referred to as a capacitor hole. In some embodiments, a horizontal width of the removed portion of the fourth sub-mold layer MOL4a may be greater than a horizontal width of the removed portion of the third sub-mold layer MOL3a, the horizontal width of the removed portion of the third sub-mold layer MOL3a may be greater than a horizontal width of the removed portion of the second sub-mold layer MOL2a, and the horizontal width of the removed portion of the second sub-mold layer MOL2a may be greater than a horizontal width of the removed portion of the first sub-mold layer MOL1a.

In the expanded capacitor hole CPHE, a first support hole, a second support hole, a third support hole, and a fourth support hole that pass through a first support pattern SPT1, a second support pattern SPT2, a third support pattern SPT3, and a fourth support pattern SPT4, respectively, may have a first horizontal width W1, a second horizontal width W2, a third horizontal width W3, and a fourth horizontal width W4, respectively. A first mold hole, a second mold hole, a third mold hole, and a fourth mold hole that pass through the first sub-mold layer MOL1a, the second sub-mold layer MOL2a, the third sub-mold layer MOL3a, and the fourth sub-mold layer MOL4a, respectively, may respectively have a fifth horizontal width W5, a sixth horizontal width W6, a seventh horizontal width W7, and an eighth horizontal width W8. The first horizontal width W1, the second horizontal width W2, the third horizontal width W3, and the fourth horizontal width W4 may have the same value. The fifth horizontal width W5, the sixth horizontal width W6, the seventh horizontal width W7, and the eighth horizontal width W8 may be greater than the first horizontal width W1, the second horizontal width W2, the third horizontal width W3, and the fourth horizontal width W4, respectively. The eighth horizontal width W8 may be greater than the seventh horizontal width W7, the seventh horizontal width W7 may be greater than the sixth horizontal width W6, and the sixth horizontal width W6 may be greater than the fifth horizontal width W5. That is, the horizontal widths of the first to fourth mold holes may increase from the first mold hole to the fourth mold hole.

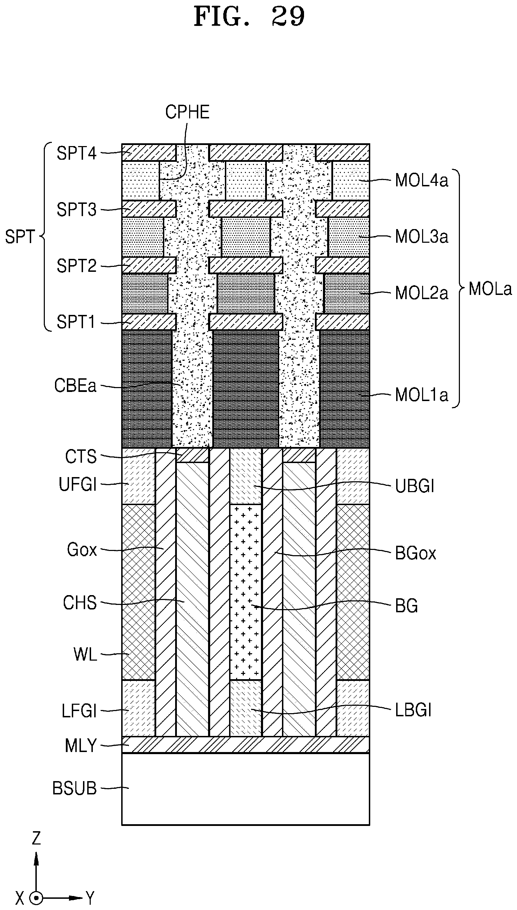

Referring to FIG. 29, a lower electrode CBEa may be formed so as to fill the expanded capacitor hole CPHE. The lower electrode CBEa may pass through the plurality of mold layers MOLa and the plurality of support patterns SPT. The plurality of support patterns SPT may be in contact with sidewalls of the lower electrode CBEa.

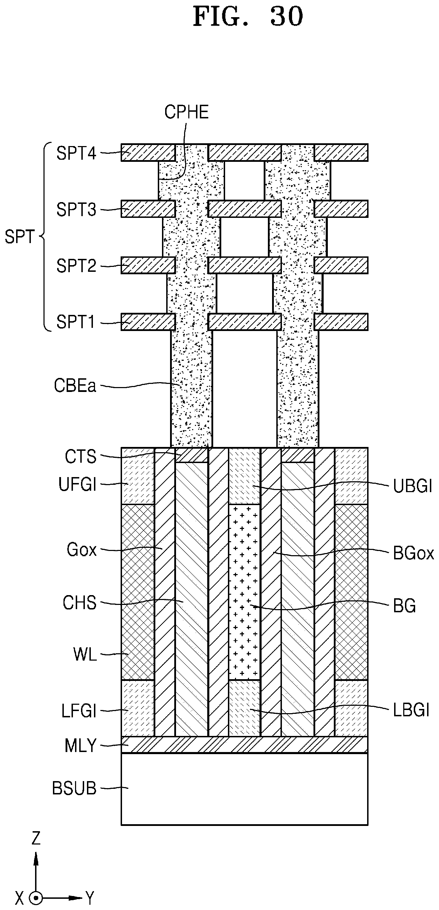

Referring to FIGS. 29 and 30 together, the plurality of mold layers MOLa may be removed.

Referring to FIG. 31, a capacitor dielectric layer CDIa and an upper electrode CTEa may be formed. The capacitor dielectric layer CDIa may cover surfaces of a plurality of lower electrodes CBEa and surfaces of the plurality of support patterns SPT, and the upper electrode CTEa may fill spaces between the plurality of lower electrodes CBEa and the plurality of support patterns SPT and cover the capacitor dielectric layer CDIa. Accordingly, a plurality of capacitor structures CAPa including the plurality of lower electrodes CBEa, the capacitor dielectric layer CDIa, and the upper electrode CTEa may be formed. Consequently, a semiconductor memory device 10a may be formed.

The lower electrode CBEa may include a first electrode portion CBE1 between the lower surface of the lower electrode CBEa and the upper surface of the first support pattern SPT1, a second electrode portion CBE2 between the upper surface of the first support pattern SPT1 and the upper surface of the second support pattern SPT2, a third electrode portion CBE3 between the upper surface of the second support pattern SPT2 and the upper surface of the third support pattern SPT3, and a fourth electrode portion CBE4 between the upper surface of the third support pattern SPT3 and the upper surface of the fourth support pattern SPT4. A region of the first electrode portion CBE1, surrounded by the first support pattern SPT1, may have the first horizontal width W1, and the remaining region thereof may have the fifth horizontal width W5. A region of the second electrode portion CBE2, surrounded by the second support pattern SPT2, may have the second horizontal width W2, and the remaining region thereof may have the sixth horizontal width W6. A region of the third electrode portion CBE3, surrounded by the third support pattern SPT3, may have the third horizontal width W3, and the remaining region thereof may have the seventh horizontal width W7. A region of the fourth electrode portion CBE4, surrounded by the fourth support pattern SPT4, may have the fourth horizontal width W4, and the remaining region thereof may have the eighth horizontal width W8.

The region of the first electrode portion CBE1, surrounded by the first support pattern SPT1, the region of the second electrode portion CBE2, surrounded by the second support pattern SPT2, the region of the third electrode portion CBE3, surrounded by the third support pattern SPT3, and the region of the fourth electrode portion CBE4, surrounded by the fourth support pattern SPT4, may each have the constant horizontal width from a lowermost end to an uppermost end of each of the regions described above. The remaining region of the first electrode portion CBE1, which is not surrounded by the first support pattern SPT1, may have the constant horizontal width from a lowermost end to an uppermost end, that is, from the lower surface of the lower electrode CBEa to the lower surface of the first support pattern SPT1. The remaining region of the second electrode portion CBE2, which is not surrounded by the second support pattern SPT2, may have a constant horizontal width from a lowermost end to an uppermost end, that is, from the upper surface of the first support pattern SPT1 to the lower surface of the second support pattern SPT2. The remaining region of the third electrode portion CBE3, which is not surrounded by the third support pattern SPT3, may have a constant horizontal width from a lowermost end to an uppermost end, that is, from the upper surface of the second support pattern SPT2 to the lower surface of the third support pattern SPT3. The remaining region of the fourth electrode portion CBE4, which is not surrounded by the fourth support pattern SPT4, may have a constant horizontal width from a lowermost end to an uppermost end, that is, from the upper surface of the third support pattern SPT3 to the lower surface of the fourth support pattern SPT4.

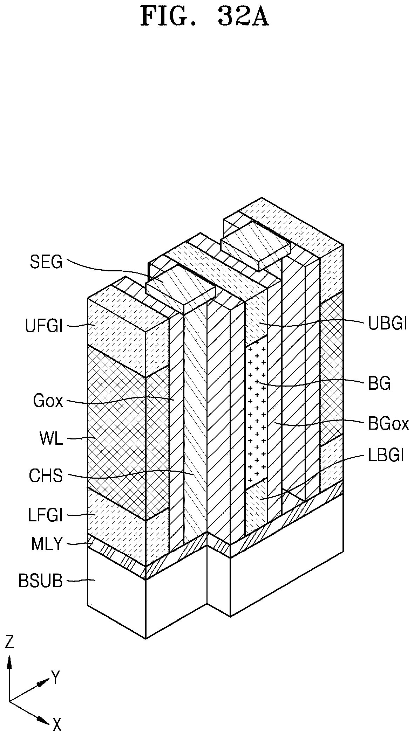

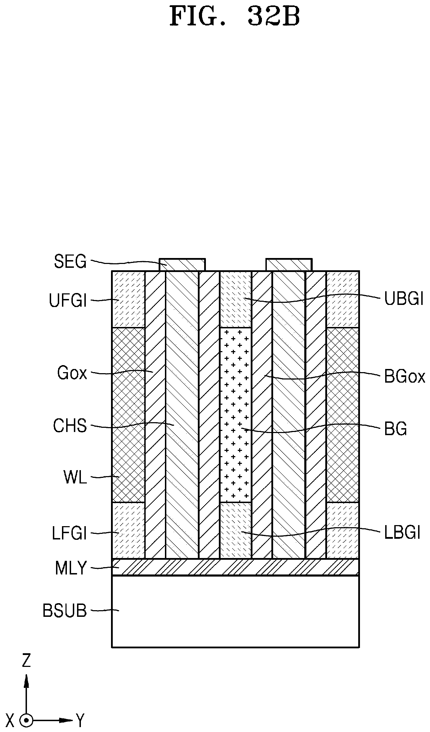

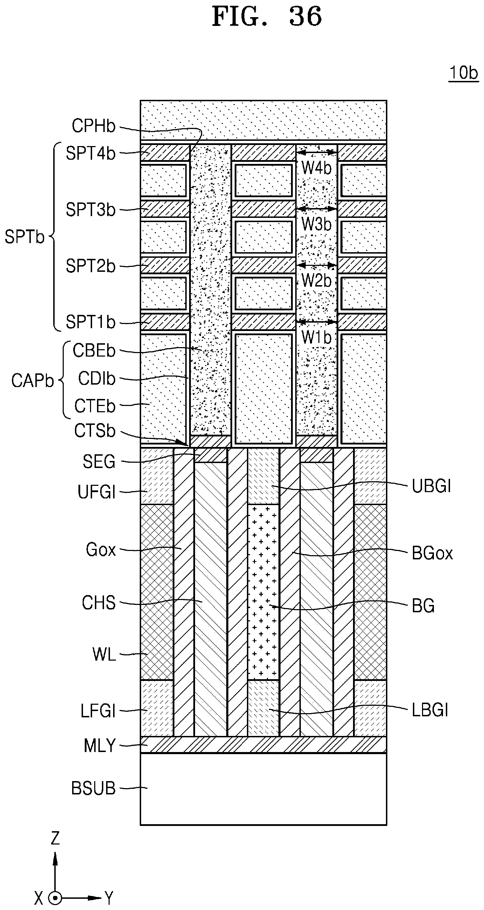

FIGS. 32A to 35B are perspective views and cross-sectional views illustrating a method of manufacturing a semiconductor memory device according to one or more example embodiments and FIG. 36 is a cross-sectional view showing the semiconductor memory device according to one or more example embodiments. Specifically, FIGS. 32A, 33A, 34A, and 35A are perspective views illustrating the method of manufacturing the semiconductor memory device according to one or more example embodiments and FIGS. 32B, 33B, 34B, and 35B are cross-sectional views illustrating the method of manufacturing the semiconductor memory device according to one or more example embodiments. Specifically, FIGS. 32A to 35B are cross-sectional views showing operations after FIGS. 3A and 3B.

Referring to FIGS. 32A and 32B together, a selective epitaxial growth (SEG) layer SEG may be formed on a channel structure CHS. The SEG layer SEG may be formed by performing selective epitaxial growth using a channel structure CHS as a seed. The SEG layer SEG may have a horizontal width and a horizontal area greater than those of the channel structure CHS.

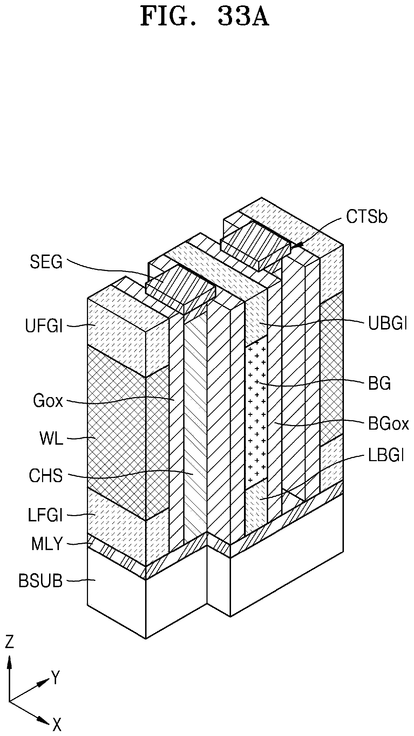

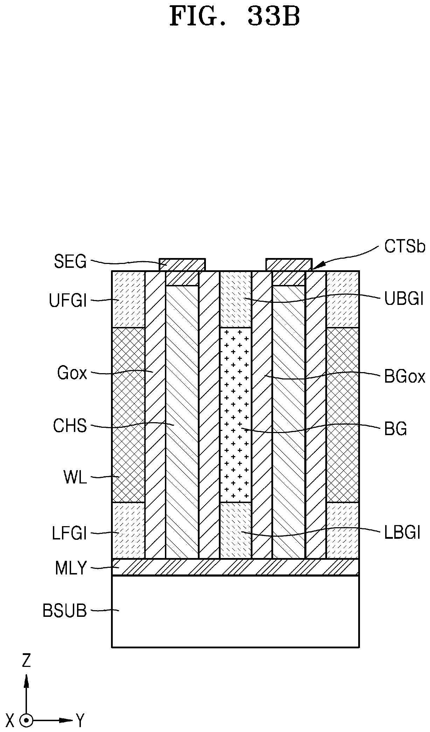

Referring to FIGS. 33A and 33B, a connection structure CTSb may be formed by implanting impurities into the SEG layer SEG. In some embodiments, the connection structure CTSb may be formed by implanting impurities into the SEG layer SEG and an upper portion of the channel structure CHS in contact with the SEG layer SEG. For example, the connection structure CTSb may be formed by implanting n-type impurities into the upper portion of the channel structure CHS and the SEG layer SEG.

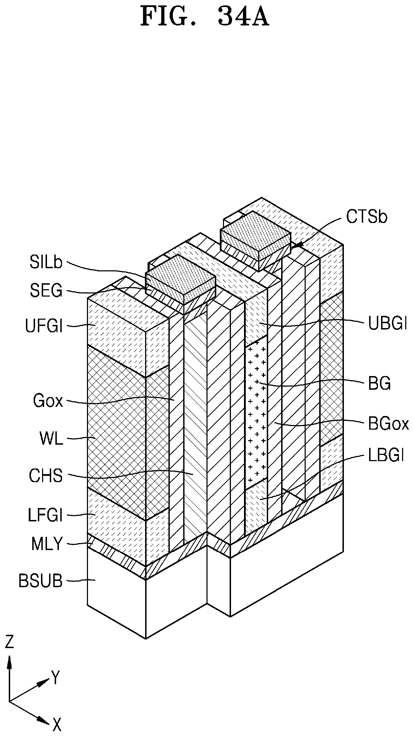

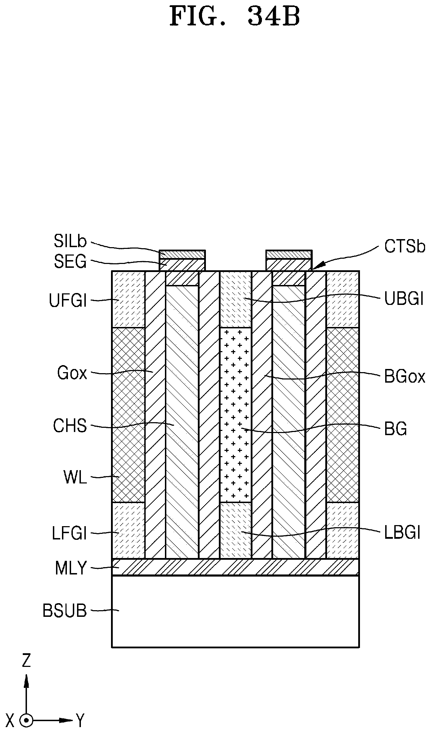

Referring to FIGS. 34A and 34B together, a silicide material layer SILb may be formed on the connection structure CTSb. The silicide material layer SILb may have a horizontal width and horizontal area greater than those of the channel structure CHS. For example, the silicide material layer SILb may completely cover the upper surface of the connection structure CTSb.

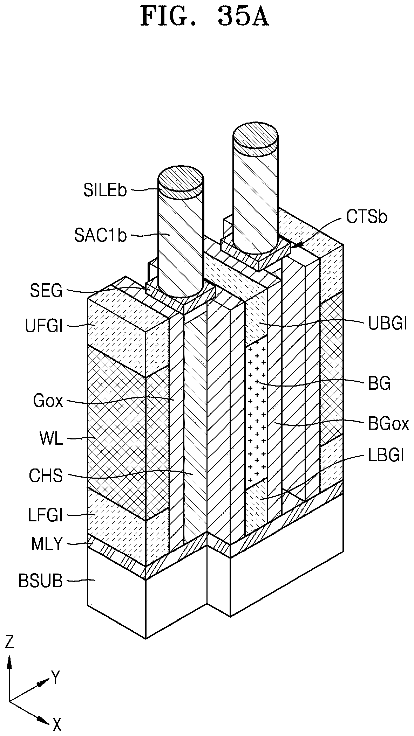

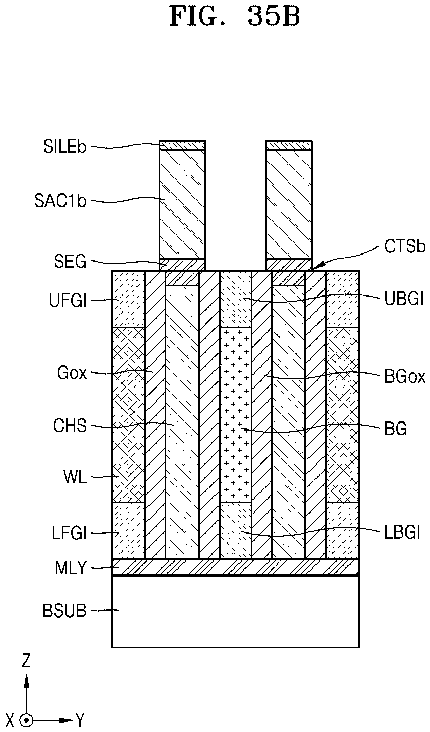

Referring to FIGS. 35A and 35B together, MIC may be performed by heating the connection structure CTSb and the silicide material layer SILb and injecting semiconductor material precursors into the connection structure CTSb and the silicide material layer SILb, and thus, a first sub-sacrificial semiconductor layer SAC1b may be formed. The first sub-sacrificial semiconductor layer SAC1b may have a cylindrical shape with a constant horizontal width. The horizontal width of the first sub-sacrificial semiconductor layer SAC1b may be greater than the horizontal width of the channel structure CHS.

Referring to FIG. 36, a plurality of support patterns SPTb, a plurality of lower electrodes CBEb, a capacitor dielectric layer CDIb, and an upper electrode CTEb may be formed with reference to FIGS. 22 to 23. The plurality of lower electrodes CBEb may fill a plurality of capacitor holes CPHb passing through the plurality of support patterns SPTb, the capacitor dielectric layer CDIb may cover surfaces of the plurality of lower electrodes CBEb and surfaces of the plurality of support patterns SPTb, and the upper electrode CTEb may fill spaces between the plurality of lower electrodes CBEb and the plurality of support patterns SPTb and may cover the capacitor dielectric layer CDIb. Accordingly, a plurality of capacitor structures CAPb including the plurality of lower electrodes CBEb, the capacitor dielectric layer CDIb, and the upper electrode CTEb may be formed. Consequently, a semiconductor memory device 10b may be formed. The plurality of support patterns SPTb may include a first support pattern SPT1b, a second support pattern SPT2b, a third support pattern SPT3b, and a fourth support pattern SPT4b, which are at different vertical levels so as to be spaced apart from each other in the vertical direction (Z direction).

The lower electrode CBEb may have a first horizontal width W1b in an area between a lower surface of the lower electrode CBEb and an upper surface of the first support pattern SPT1b in the vertical direction (Z direction), a second horizontal width W2b in an area between the upper surface of the first support pattern SPT1b and an upper surface of the second support pattern SPT2b in the vertical direction (Z direction), a third horizontal width W3b in an area between the upper surface of the second support pattern SPT2b and an upper surface of the third support pattern SPT3b in the vertical direction (Z direction), and a fourth horizontal width W4b in an area between the upper surface of the third support pattern SPT3b and an upper surface of the fourth support pattern SPT4b in the vertical direction (Z direction). The first horizontal width W1b, the second horizontal width W2b, the third horizontal width W3b, and the fourth horizontal width W4b may have the same value. The first horizontal width W1b, the second horizontal width W2b, the third horizontal width W3b, and the fourth horizontal width W4b may be greater than the horizontal width of the channel structure CHS and equal to the horizontal width of the connection structure CTSb. The lower electrode CBEb may have a constant horizontal width from a lowermost end to an uppermost end of the lower electrode CBEb.

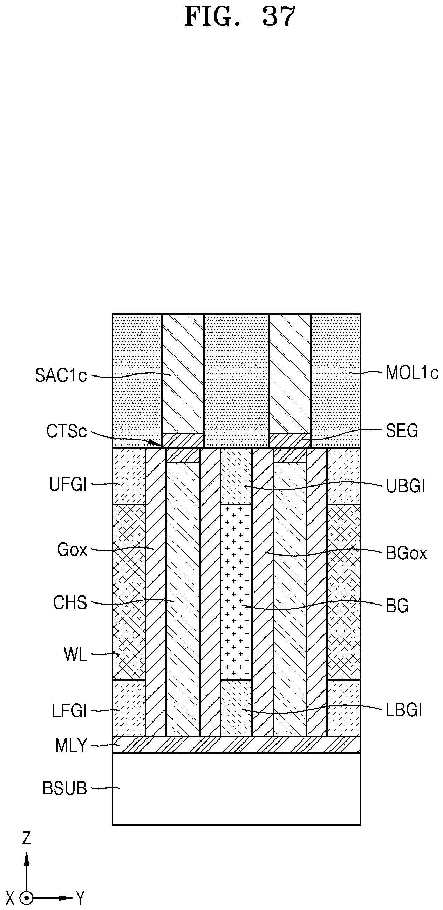

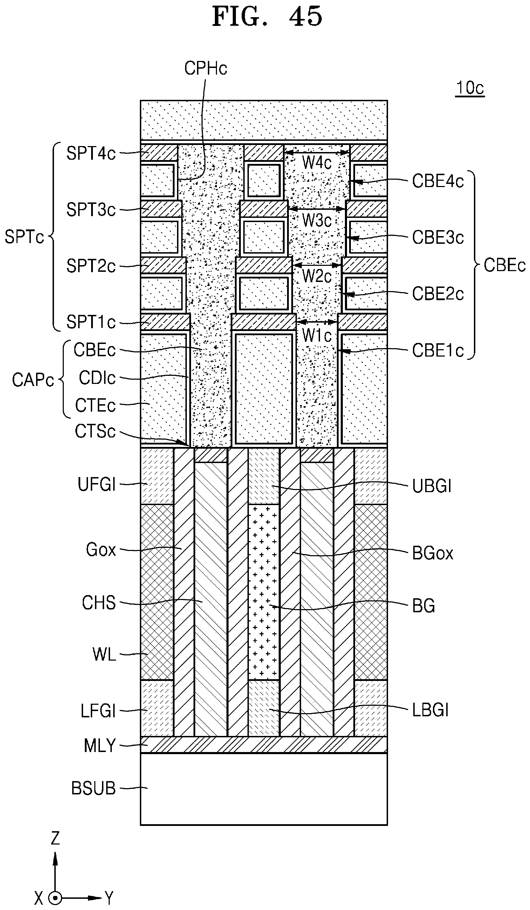

FIGS. 37 to 44 are cross-sectional views illustrating a method of manufacturing a semiconductor memory device according to one or more example embodiments and FIG. 45 is a cross-sectional view showing the semiconductor memory device according to one or more example embodiments.

Referring to FIG. 37, a first sub-sacrificial semiconductor layer SAC1c may be formed on a connection structure CTSc with reference to FIGS. 34A to 35B and a first sub-mold layer MOL1c may formed to cover a side surface of the first sub-sacrificial semiconductor layer SAC1c with reference to FIG. 20. The connection structure CTSc may be substantially the same as the connection structure CTSb shown in FIGS. 33A and 33B.

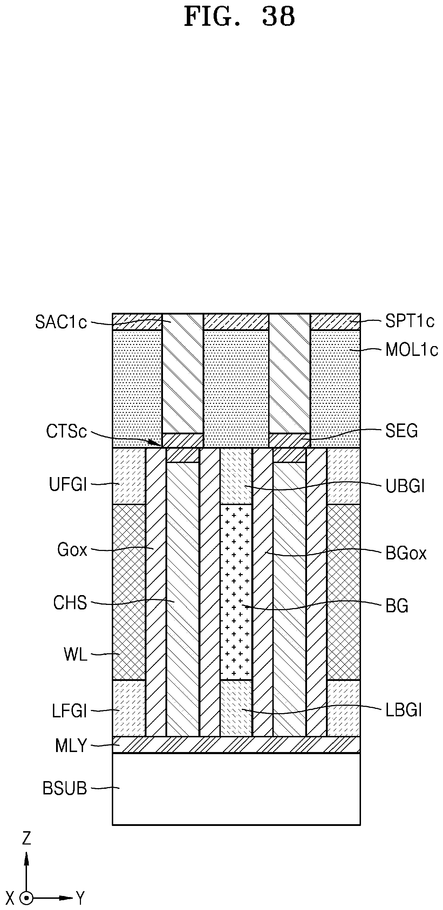

Referring to FIG. 38, an upper portion of the first sub-mold layer MOL1c may be removed so that an upper portion of the first sub-sacrificial semiconductor layer SAC1c is exposed. Subsequently, a first support pattern SPTIc may be formed on the first sub-mold layer MOL1c so as to cover a side surface of an upper portion of the first sub-sacrificial semiconductor layer SAC1c.

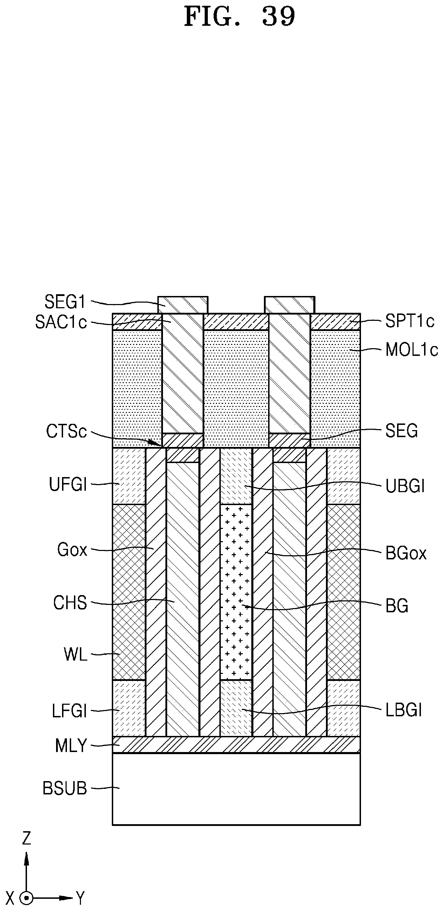

Referring to FIG. 39, a first sub-SEG layer SEG1 may be formed on the first sub-sacrificial semiconductor layer SAC1c. The first sub-SEG layer SEG1 may be formed by performing selective epitaxial growth using the first sub-sacrificial semiconductor layer SAC1c as a seed. The first sub-SEG layer SEG1 may have a horizontal width and horizontal area greater than those of the first sub-sacrificial semiconductor layer SAC1c.

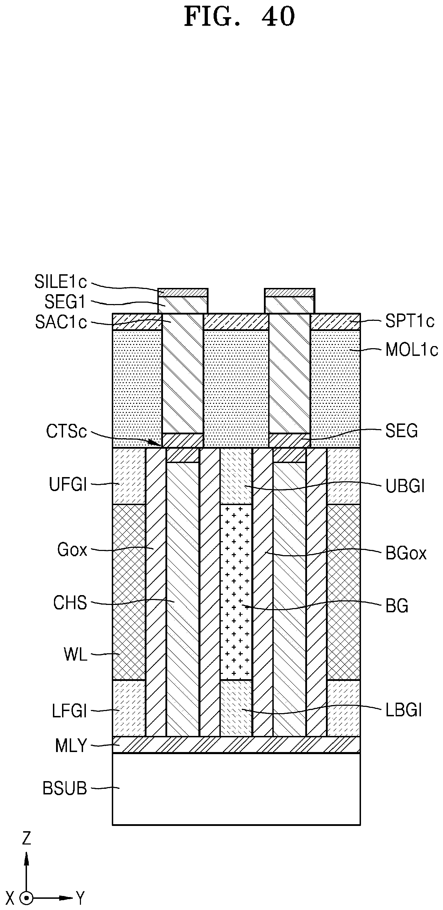

Referring to FIG. 40, a first sub-induced silicide material layer SILE1c may be formed on an upper surface of the first sub-SEG layer SEG1.

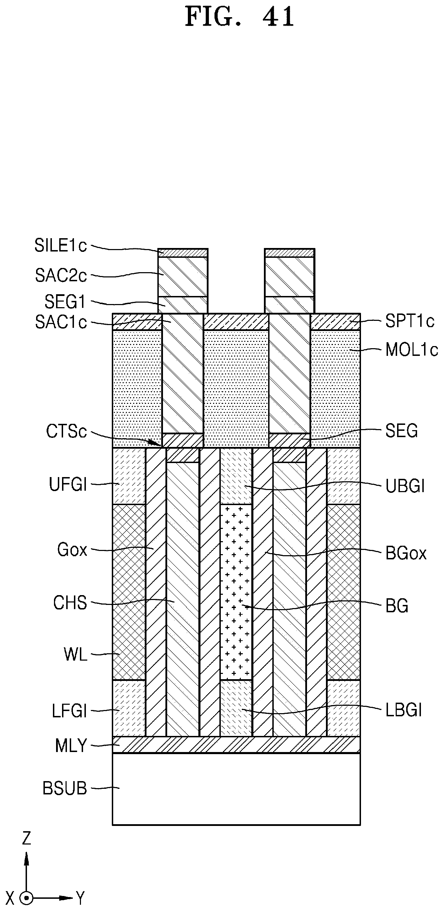

Referring to FIGS. 40 and 41 together, the MIC may be performed by heating the first sub-induced silicide material layer SILE1c and injecting semiconductor material precursors into the first sub-induced silicide material layer SILE1c, and thus, a second sub-sacrificial semiconductor layer SAC2c may be formed above the first sub-sacrificial semiconductor layer SAC1c.

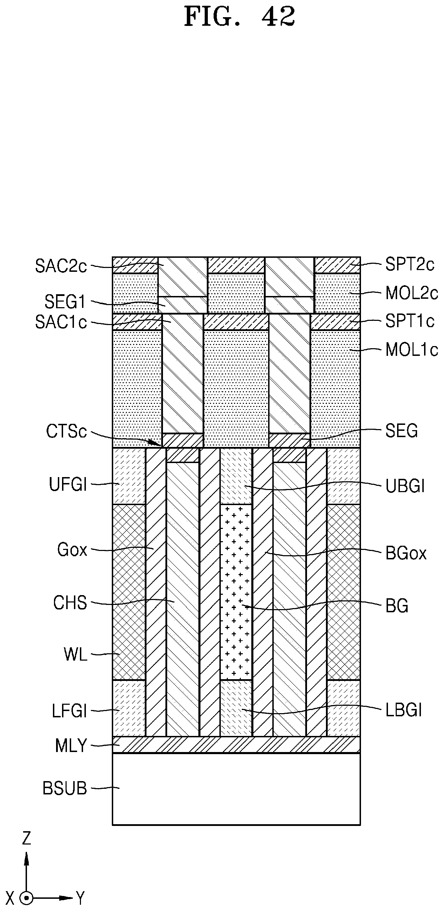

Referring to FIGS. 41 and 42 together, a second sub-mold layer MOL2c may be formed covering the second sub-sacrificial semiconductor layer SAC2c and the first sub-induced silicide material layer SILE1c. Subsequently, an upper portion of the second sub-mold layer MOL2c and the first sub-induced silicide material layer SILE1c may be removed to expose an upper portion of the second sub-sacrificial semiconductor layer SAC2c. Subsequently, a second support pattern SPT2c may be formed on the second sub-mold layer MOL2c so as to cover a side surface of an upper portion of the second sub-sacrificial semiconductor layer SAC2c.

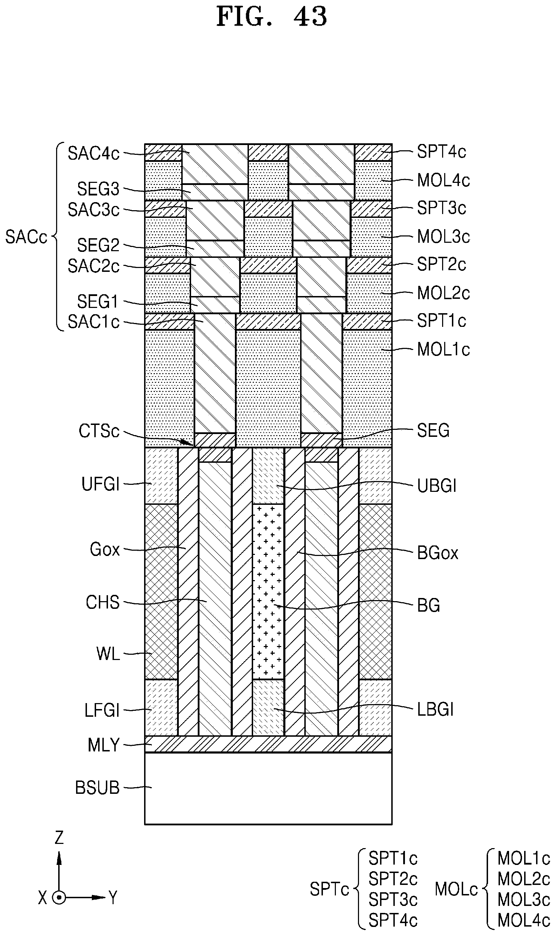

Referring to FIGS. 42 and 43 together, there are formed a second sub-SEG layer SEG2 on the second sub-sacrificial semiconductor layer SAC2c, a third sub-sacrificial semiconductor layer SAC3c on the second sub-SEG layer SEG2, a third sub-mold layer MOL3c covering a portion of a side surface of the third sub-sacrificial semiconductor layer SAC3c and a side surface of the second sub-SEG layer SEG2, a third support pattern SPT3c disposed on the third sub-mold layer MOL3c and covering a side surface of an upper portion of the third sub-sacrificial semiconductor layer SAC3c, a third sub-SEG layer SEG3 on the third sub-sacrificial semiconductor layer SAC3c, a fourth sub-sacrificial semiconductor layer SAC4c on the third sub-SEG layer SEG3, a fourth sub-mold layer MOL4c covering a portion of a side surface of the fourth sub-sacrificial semiconductor layer SAC4c and a side surface of the third sub-SEG layer SEG3, and a fourth support pattern SPT4c disposed on the fourth sub-mold layer MOL4c and covering a side surface of an upper portion of the fourth sub-sacrificial semiconductor layer SAC4c, with reference to FIGS. 23 and 25 and FIGS. 39 to 42 together. A plurality of sacrificial semiconductor layers SACc may include the first sub-sacrificial semiconductor layer SAC1c, the second sub-sacrificial semiconductor layer SAC2c, the third sub-sacrificial semiconductor layer SAC3c, and the fourth sub-sacrificial semiconductor layer SAC4c. A plurality of support patterns SPTc include the first support pattern SPT1c, the second support pattern SPT2c, the third support pattern SPT3c, and the fourth support pattern SPT4c, and a plurality of mold layers MOLc include the first sub-mold layer MOL1c, the second sub-mold layer MOL2c, the third sub-mold layer MOL3c, and the fourth sub-mold layer MOL4c. The SEG layer SEG, the first sub-SEG layer SEG1, the second sub-SEG layer SEG2, and the third sub-SEG layer SEG3 may be referred to as a first SEG layer, a second SEG layer, a third SEG layer, and a fourth SEG layer, respectively.

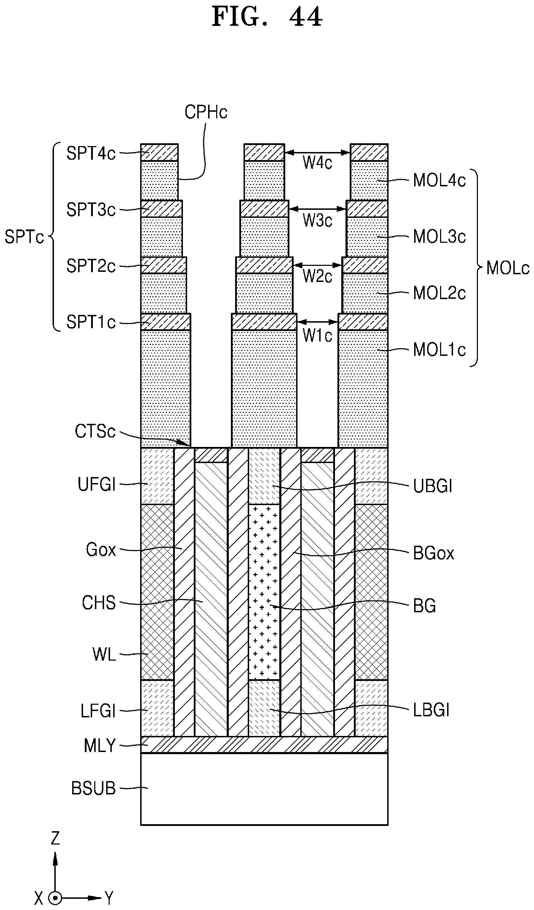

Referring to FIGS. 43 and 44 together, the SEG layer SEG, the first sub-SEG layer SEG1, the second sub-SEG layer SEG2, the third sub-SEG layer SEG3, and the plurality of sacrificial semiconductor layers SACc may be removed, and accordingly, a capacitor hole CPHc may be formed which passes through the plurality of mold layers MOLc and the plurality of support patterns SPTc.

In the capacitor hole CPHc, a region passing through the first support pattern SPT1c and a region passing through the first sub-mold layer MOL1c may have a first horizontal width W1c, a region passing through the second support pattern SPT2c and a region passing through the second sub-mold layer MOL2c may have a second horizontal width W2c, a region passing through the third support pattern SPT3c and a region passing through the third sub-mold layer MOL3c may have a third horizontal width W3c, and a region passing through the fourth support pattern SPT4c and a region passing through the fourth sub-mold layer MOL4c may have a fourth horizontal width W4c. The first horizontal width W1c may be greater than the horizontal width of the channel structure CHS, the second horizontal width W2c may be greater than the first horizontal width W1c, the third horizontal width W3c may be greater than the second horizontal width W2c, and the fourth horizontal width W4c may be greater than the third horizontal width W3c.

Referring to FIGS. 44 and 45 together, a lower electrode CBEc may be formed to fill the capacitor hole CPHc, and a plurality of mold layers MOLc may be removed. Subsequently, a capacitor dielectric layer CDIc and an upper electrode CTEc may be formed. The capacitor dielectric layer CDIc may cover surfaces of a plurality of lower electrodes CBEc and surfaces of the plurality of support patterns SPTc, and the upper electrode CTEc may fill spaces between the plurality of lower electrodes CBEc and the plurality of support patterns SPTc and cover the capacitor dielectric layer CDIc. Accordingly, a plurality of capacitor structures CAPc including the plurality of lower electrodes CBEc, the capacitor dielectric layer CDIc, and the upper electrode CTEc may be formed. Consequently, a semiconductor memory device 10c may be formed.

The lower electrode CBEc may include a first electrode portion CBE1c between a lower surface of the lower electrode CBEc and an upper surface of the first support pattern SPT1c in the vertical direction (Z direction), a second electrode portion CBE2c between the upper surface of the first support pattern SPT1c and an upper surface of the second support pattern SPT2c in the vertical direction (Z direction), a third electrode portion CBE3c between the upper surface of the second support pattern SPT2c and an upper surface of the third support pattern SPT3c in the vertical direction (Z direction), and a fourth electrode portion CBE4c between the upper surface of the third support pattern SPT3c and an upper surface of the fourth support pattern SPT4c in the vertical direction (Z direction). The first electrode portion CBE1c may have the first horizontal width W1c, the second electrode portion CBE2c may have the second horizontal width W2c, the third electrode portion CBE3c may have the third horizontal width W3c, and the fourth electrode portion CBE4c may have the fourth horizontal width W4c. The first electrode portion CBE1c, the second electrode portion CBE2c, the third electrode portion CBE3c, and the fourth electrode portion CBE4c may each have the constant horizontal width from a lowermost end to an uppermost end thereof. The fourth horizontal width W4c, which is the horizontal width of the fourth electrode portion CBE4c, may be greater than the third horizontal width W3c, which is the horizontal width of the third electrode portion CBE3c. The third horizontal width W3c, which is the horizontal width of the third electrode portion CBE3c, may be greater than the second horizontal width W2c, which is the horizontal width of the second electrode portion CBE2c. The second horizontal width W2c, which is the horizontal width of the second electrode portion CBE2c, may be greater than the first horizontal width W1c, which is the horizontal width of the first electrode portion CBE1c. The first horizontal width W1c, which is the horizontal width of the first electrode portion CBE1c, may be greater than the horizontal width of the channel structure CHS.

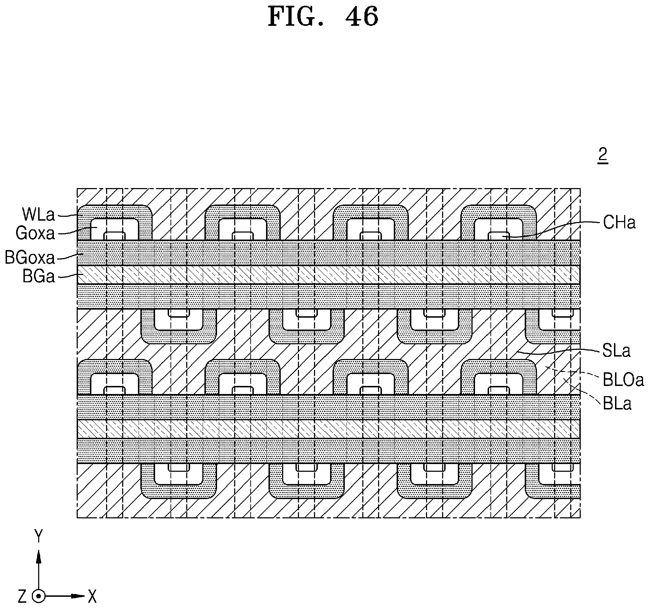

FIG. 46 is a plan layout showing a semiconductor memory device 2 according to one or more example embodiments.

Referring to FIG. 46, the semiconductor memory device 2 may include a plurality of word lines WLa extending in a first horizontal direction (X direction), a plurality of bit lines BLa extending in a second horizontal direction (Y direction) different from the first horizontal direction (X direction), a plurality of back gate lines BGa extending in the first horizontal direction (X direction), and a plurality of channel patterns CHa extending in a vertical direction (Z direction).

The plurality of word lines WLa and the plurality of back gate lines BGa may be spaced apart from each other in the second horizontal direction (Y direction) and extend, parallel to each other, in the first horizontal direction (X direction). For example, the plurality of word lines WLa and the plurality of back gate lines BGa may be alternately arranged in the second horizontal direction (Y direction).

The plurality of bit lines BLa may be spaced apart from each other in the first horizontal direction (X direction) and extend, parallel to each other, in the second horizontal direction (Y direction). A cover insulating layer BLOa may cover the plurality of bit lines BLa. The cover insulating layer BLOa may conformally cover the plurality of bit lines BLa but not completely fill spaces between the plurality of bit lines BLa. A shield conductive layer SLa may cover the plurality of bit lines BLa with the cover insulating layer BLOa therebetween. The spaces between the plurality of bit lines BLa that are not completely filled by the cover insulating layer BLOa may be filled with the shield conductive layer SLa.

The plurality of channel patterns CHa may be arranged in a row in the first horizontal direction (X direction) between one word line WLa and one back gate line BGa that are adjacent to each other among the plurality of word lines WLa and the plurality of back gate lines BGa. The channel patterns CHa between a pair of adjacent back gate lines BGa among the plurality of back gate lines BGa may be arranged in a zigzag pattern in the first horizontal direction (X direction). For example, the channel patterns CHa may be arranged to form a pair of rows extending in the first horizontal direction (X direction) between the pair of adjacent back gate lines BGa among the plurality of back gate lines BGa. The channel patterns CHa arranged in the pair of rows between the pair of adj acent back gate lines BGa may be alternately arranged in the pair of rows to form the zigzag pattern in the first horizontal direction (X direction).

Each of the plurality of channel patterns CHa may include a first sidewall facing the back gate line BGa and a second sidewall facing the word line WLa and connected to edges of the first sidewall. The first sidewall may be flat and the second sidewall may be curved. That is, in a plan view, the first sidewall may have a straight shape and the second sidewall may have a curved shape. For example, in a plan view, each of the plurality of channel patterns CHa may have a rectangular-like shape, in which two corners facing the word line WLa are rounded, or may have a shape in which the second sidewall has a circular arc or elliptical arc.

A gate insulating layer Goxa may be located between the channel pattern CHa and the word line WLa and a back gate insulating layer BGoxa may be located between the channel pattern CHa and the back gate line BGa. In some embodiments, the gate insulating layer Goxa may surround at least a portion of the channel pattern CHa in a plan view. In some embodiments, the back gate insulating layers BGoxa may extend in the first horizontal direction (X direction) along both sides of the back gate line BGa in the second horizontal direction (Y direction). The first sidewall of the channel pattern CHa may be covered with the back gate insulating layer BGoxa and the second sidewall of the channel pattern CHa may be covered with the gate insulating layer Goxa.

The plurality of bit lines BLa may be spaced apart from each other in the first horizontal direction (X direction) and extend, parallel to each other, in the second horizontal direction (Y direction). The plurality of bit lines BLa may extend in the second horizontal direction (Y direction) and be electrically connected to the plurality of channel patterns CHa. For example, the plurality of bit lines BLa may be electrically connected to a first end of both ends of each of the plurality of channel patterns CHa in the vertical direction (Z direction). One bit line BLa may be electrically connected to only one of the channel patterns CHa arranged between a pair of back gate lines BGa adjacent to each other among the plurality of back gate lines BGa. The pair of bit lines BLa adjacent to each other in the first horizontal direction (X direction) may be electrically connected to the channel patterns CHa which are arranged in different rows among the channel patterns CHa arranged in the pair of rows between the pair of back gate lines BGa.

The bit line BLa, the word line WLa, the channel pattern CHa adjacent to a portion of the word line WLa intersecting with the bit line BLa in a plan view, and the gate insulating layer Goxa between the word line WLa and the channel pattern CHa may constitute a vertical channel transistor.

Embodiments are set out in the following Clauses:
Clause 1. A method of manufacturing a semiconductor memory device, the method comprising:
   forming, on a substrate, a channel structure comprising a channel pattern;
   forming, on the channel structure, a silicide material layer comprising an alloy of a semiconductor material and a metal, the metal comprising a eutectic composition;
   forming a sacrificial semiconductor layer between the channel structure and the silicide material layer, and forming a mold layer surrounding the sacrificial semiconductor layer;
   forming a capacitor hole by removing the sacrificial semiconductor layer;
   forming a lower electrode that fills the capacitor hole;
   removing the mold layer;
   forming a capacitor dielectric layer that covers a surface of the lower electrode; and
   forming an upper electrode that covers the capacitor dielectric layer.
Clause 2. The method of Clause 1, further comprising, prior to the forming the silicide material layer, forming a connection structure on the channel structure,
   wherein the sacrificial semiconductor layer has a horizontal width equal to a horizontal width of the connection structure.
Clause 3. The method of Clause 1 or Clause 2, wherein the forming the sacrificial semiconductor layer comprises forming the sacrificial semiconductor layer by performing a metal-induced crystallization by injecting a semiconductor material precursor into the channel structure and the silicide material layer while heating the channel structure and the silicide material layer, and
   wherein the sacrificial semiconductor layer has a cylindrical shape.
Clause 4. The method of Clause 3, wherein the silicide material layer is converted into an induced silicide material layer having a circular planar shape and a hemispherical shape due to a surface tension when performing the metal-induced crystallization.
Clause 5. The method of Clause 4, wherein the sacrificial semiconductor layer comprises a plurality of sub-sacrificial semiconductor layers, and the mold layer comprises a plurality of sub-mold layers, and
   wherein the forming the sacrificial semiconductor layer and the forming the mold layer comprise:
   a first operation of forming one sub-sacrificial semiconductor layer, among the plurality of sub-sacrificial semiconductor layers, by performing the metal-induced crystallization;
   a second operation of forming one sub-mold layer, among the plurality of sub-mold layers, that surrounds a portion of a side surface of the one sub-sacrificial semiconductor layer;
   a third operation of forming a support pattern that covers a side surface of an upper portion of the one sub-sacrificial semiconductor layer; and
   repeating the first operation, the second operation, and the third operation at least twice.
Clause 6. The method of Clause 5, wherein the induced silicide material layer is removed after the one sub-mold layer is formed, and
   wherein the method further comprises forming another silicide material layer on the one sub-mold layer before forming another sub-mold layer among the plurality of sub-mold layers.
Clause 7. The method of Clause 5 or Clause 6, wherein each sub-sacrificial semiconductor layer of the plurality of sub-sacrificial semiconductor layers has a constant horizontal width from a lowermost end to an uppermost end of each sub-sacrificial semiconductor layer, and
   wherein a sub-sacrificial semiconductor layer at a higher level among the plurality of sub-sacrificial semiconductor layers has a horizontal width greater than a horizontal width of a sub-sacrificial semiconductor layer at a lower level among the plurality of sub-sacrificial semiconductor layers.
Clause 8. The method of any of Clauses 1-6, wherein the sacrificial semiconductor layer has a constant horizontal width from a lowermost end to an uppermost end of the sacrificial semiconductor layer.
Clause 9. The method of any preceding Clause, further comprising, prior to the forming the silicide material layer, forming, on an upper surface of the channel structure, a selective epitaxial growth (SEG) layer having a horizontal width greater than a horizontal width of the channel structure,
   wherein the silicide material layer is formed on the SEG layer.
Clause 10. A method of manufacturing a semiconductor memory device, the method comprising:
   forming a plurality of word lines, a plurality of channel structures, and a plurality of bit lines on a substrate, wherein the plurality of word lines extend in a first horizontal direction, wherein the plurality of channel structures are adjacent to the plurality of word lines and arranged in rows in the first horizontal direction, each channel structure of the plurality of channel structures comprising a channel pattern extending in a vertical direction, and wherein the plurality of bit lines extend in a second horizontal direction, different from the first horizontal direction, and are electrically connected to first ends of a plurality of the channel patterns;
   respectively forming, on the plurality of channel structures, a plurality of silicide material layers, each silicide material layer of the plurality of silicide material layers comprising an alloy of a semiconductor material and a metal, the metal comprising a eutectic composition;
   performing a metal-induced crystallization to convert the plurality of silicide material layers into a plurality of induced silicide material layers having a circular planar shape;
   forming a plurality of sacrificial semiconductor layers between the plurality of induced silicide material layers and upper surfaces of the plurality of channel structures, and forming a mold layer surrounding the plurality of sacrificial semiconductor layers;
   forming a plurality of capacitor holes by removing the plurality of sacrificial semiconductor layers;
   forming a plurality of lower electrodes that respectively fill the plurality of capacitor holes and are respectively electrically connected to second ends of the plurality of channel patterns;
   removing the mold layer;
   forming a capacitor dielectric layer that covers surfaces of the plurality of lower electrodes; and
   forming an upper electrode that covers the capacitor dielectric layer.
11. The method of claim 10, wherein each sacrificial semiconductor layer of the plurality of sacrificial semiconductor layers comprises a plurality of sub-sacrificial semiconductor layers, and the mold layer comprises a plurality of sub-mold layers, and
   wherein the forming the plurality of sacrificial semiconductor layers and forming the mold layer comprise:
   a first operation of forming one sub-sacrificial semiconductor layer among the plurality of sub-sacrificial semiconductor layers by performing the metal-induced crystallization;
   a second operation of forming one sub-mold layer, among the plurality of sub-mold layers, that surrounds a portion of a side surface of the one sub-sacrificial semiconductor layer;
   a third operation of forming a support pattern that covers a side surface of an upper portion of the one sub-sacrificial semiconductor layer; and
   repeating the first operation, the second operation, and the third operation are at least three times.
12. The method of claim 11, wherein a plurality of the support patterns are formed, and the plurality of support patterns respectively cover side surfaces of upper portions of the plurality of sub-sacrificial semiconductor layers,
   wherein the plurality of support patterns comprise a plurality of support holes respectively filled with portions of the plurality of sub-sacrificial semiconductor layers, andwherein the plurality of support holes of the plurality of support patterns have a same horizontal width.
13. The method of claim 11, wherein a plurality of the support patterns are formed, and the plurality of support patterns respectively cover side surfaces of upper portions of the plurality of sub-sacrificial semiconductor layers,
   wherein the plurality of support patterns comprise a plurality of support holes respectively filled with portions of the plurality of sub-sacrificial semiconductor layers, andwherein, for two support patterns adjacent to each other in the vertical direction among the plurality of support patterns, a support hole of a support pattern at a higher level has a horizontal width greater than a horizontal width of a support hole of a support pattern at a lower level.
14. A method of manufacturing a semiconductor memory device, the method comprising:
   forming a plurality of word lines, a plurality of back gate lines, a plurality of channel patterns, and a plurality of bit lines on a substrate, wherein the plurality of word lines extend in a first horizontal direction, wherein the plurality of back gate lines extend in the first horizontal direction and spaced apart from the plurality of word lines in a second horizontal direction different from the first horizontal direction, wherein the plurality of channel patterns are arranged between one word line, among the plurality of word lines, and one back gate line adjacent to the one word line, among the plurality of back gate lines, the plurality of channel patterns extending in a vertical direction, and wherein the plurality of bit lines extend below the plurality of channel patterns in the second horizontal direction different from the first horizontal direction and are electrically connected to first ends of the plurality of channel patterns;
   forming a plurality of connection structures by implanting impurities into upper portions of the plurality of channel patterns;
   forming, on the plurality of connection structures, a plurality of silicide material layers, each silicide material layer of the plurality of silicide material layers comprising an alloy of a semiconductor material and a metal, the metal comprising a eutectic composition;
   forming a plurality of sacrificial semiconductor layers, a mold layer, and a plurality of support patterns on the plurality of connection structures;
   forming a plurality of capacitor holes by removing the plurality of sacrificial semiconductor layers;
   forming a plurality of lower electrodes that respectively fill the plurality of capacitor holes and are respectively electrically connected to second ends of the plurality of channel patterns;
   removing the mold layer;
   forming a capacitor dielectric layer that covers surfaces of the plurality of lower electrodes and surfaces of the plurality of support patterns; and
   forming an upper electrode that covers the capacitor dielectric layer,
   wherein each sacrificial semiconductor layer of the plurality of sacrificial semiconductor layers comprises a plurality of sub-sacrificial semiconductor layers having a cylindrical shape, and the mold layer comprises a plurality of sub-mold layers, and
   wherein the forming the plurality of sacrificial semiconductor layers, the mold layer, and the plurality of support patterns comprises:
      heating and converting the plurality of silicide material layers into a plurality of induced silicide material layers having a circular planar shape;
      a first operation of forming, between the plurality of induced silicide material layers and upper surfaces of the plurality of connection structures, one sub-sacrificial semiconductor layer, among the plurality of sub-sacrificial semiconductor layers, by injecting a semiconductor material precursor and performing a metal-induced crystallization;
      a second operation of forming one sub-mold layer, among the plurality of sub-mold layers, that surrounds a portion of a side surface of the one sub-sacrificial semiconductor layer;
      a third operation of forming one support pattern, among the plurality of support patterns, which covers a side surface of an upper portion of the one sub-sacrificial semiconductor layer; and
      repeating the first operation, the second operation, and the third operation at least three times.
15. The method of claim 14, wherein each sub-sacrificial semiconductor layer of the plurality of sub-sacrificial semiconductor layers has a constant horizontal width from a lowermost end to an uppermost end of each sub-sacrificial semiconductor layer.

While the inventive concept has been particularly shown and described with reference to example embodiments thereof, it will be understood that various changes in form and details may be made therein without departing from the scope of the following claims and their equivalents.

## Claims

1. A method of manufacturing a semiconductor memory device, the method comprising:
forming, on a substrate, a channel structure comprising a channel pattern;
forming, on the channel structure, a silicide material layer comprising an alloy of a semiconductor material and a metal, the silicide material layer comprising a eutectic composition;
forming a sacrificial semiconductor layer between the channel structure and the silicide material layer, and forming a mold layer surrounding the sacrificial semiconductor layer;
forming a capacitor hole by removing the sacrificial semiconductor layer;
forming a lower electrode that fills the capacitor hole;
removing the mold layer;
forming a capacitor dielectric layer that covers a surface of the lower electrode; and
forming an upper electrode that covers the capacitor dielectric layer.

2. The method of claim 1, further comprising, prior to the forming the silicide material layer, forming a connection structure on the channel structure,
wherein the sacrificial semiconductor layer has a horizontal width equal to a horizontal width of the connection structure.

3. The method of claim 1 or claim 2, wherein the forming the sacrificial semiconductor layer comprises forming the sacrificial semiconductor layer by performing a metal-induced crystallization by injecting a semiconductor material precursor into the channel structure and the silicide material layer while heating the channel structure and the silicide material layer, and
wherein the sacrificial semiconductor layer has a cylindrical shape.

4. The method of claim 3, wherein the silicide material layer is converted into an induced silicide material layer having a circular planar shape and a hemispherical shape due to a surface tension when performing the metal-induced crystallization.

5. The method of claim 4, wherein the sacrificial semiconductor layer comprises a plurality of sub-sacrificial semiconductor layers, and the mold layer comprises a plurality of sub-mold layers, and
wherein the forming the sacrificial semiconductor layer and the forming the mold layer comprise:
a first operation of forming one sub-sacrificial semiconductor layer, among the plurality of sub-sacrificial semiconductor layers, by performing the metal-induced crystallization;
a second operation of forming one sub-mold layer, among the plurality of sub-mold layers, that surrounds a portion of a side surface of the one sub-sacrificial semiconductor layer;
a third operation of forming a support pattern that covers a side surface of an upper portion of the one sub-sacrificial semiconductor layer; and
repeating the first operation, the second operation, and the third operation at least twice.

6. The method of claim 5, wherein the induced silicide material layer is removed after the one sub-mold layer is formed, and
wherein the method further comprises forming another silicide material layer on the one sub-mold layer before forming another sub-mold layer among the plurality of sub-mold layers.

7. The method of claim 5 or claim 6, wherein each sub-sacrificial semiconductor layer of the plurality of sub-sacrificial semiconductor layers has a constant horizontal width from a lowermost end to an uppermost end of each sub-sacrificial semiconductor layer, and
wherein a sub-sacrificial semiconductor layer at a higher level among the plurality of sub-sacrificial semiconductor layers has a horizontal width greater than a horizontal width of a sub-sacrificial semiconductor layer at a lower level among the plurality of sub-sacrificial semiconductor layers.

8. The method of any of claims 1-6, wherein the sacrificial semiconductor layer has a constant horizontal width from a lowermost end to an uppermost end of the sacrificial semiconductor layer.

9. The method of any preceding claim, further comprising, prior to the forming the silicide material layer, forming, on an upper surface of the channel structure, a selective epitaxial growth (SEG) layer having a horizontal width greater than a horizontal width of the channel structure,
wherein the silicide material layer is formed on the SEG layer.

10. The method of any of claims 1-6, wherein:
the method further comprises forming a plurality of word lines, and a plurality of bit lines on the substrate, wherein the plurality of word lines extend in a first horizontal direction, and wherein the plurality of bit lines extend in a second horizontal direction, different from the first horizontal direction;
forming a channel structure comprises forming a plurality of channel structures, wherein the plurality of channel structures are adjacent to the plurality of word lines and arranged in rows in the first horizontal direction, each channel structure of the plurality of channel structures comprising a channel pattern extending in a vertical direction, and wherein the plurality of channel structures are formed such that first ends of the plurality of channel patterns are electrically connected to the plurality of bit lines;
forming the silicide material layer comprises respectively forming, on the plurality of channel structures, a plurality of silicide material layers, each silicide material layer of the plurality of silicide material layers comprising an alloy of a semiconductor material and a metal, each silicide material layer comprising a eutectic composition;
forming the sacrificial semiconductor layer comprises:
performing a metal-induced crystallization to convert the plurality of silicide material layers into a plurality of induced silicide material layers having a circular planar shape; and
forming a plurality of sacrificial semiconductor layers between the plurality of induced silicide material layers and upper surfaces of the plurality of channel structures, and forming a mold layer surrounding the plurality of sacrificial semiconductor layers;
forming the capacitor hole comprises forming a plurality of capacitor holes by removing the plurality of sacrificial semiconductor layers;
forming the lower electrode comprises forming a plurality of lower electrodes that respectively fill the plurality of capacitor holes and are respectively electrically connected to second ends of the plurality of channel patterns; and
the capacitor dielectric layer is formed to cover surfaces of the plurality of lower electrodes.

11. The method of claim 10, wherein each sacrificial semiconductor layer of the plurality of sacrificial semiconductor layers comprises a plurality of sub-sacrificial semiconductor layers, and the mold layer comprises a plurality of sub-mold layers, and
wherein the forming the plurality of sacrificial semiconductor layers and forming the mold layer comprise:
a first operation of forming one sub-sacrificial semiconductor layer among the plurality of sub-sacrificial semiconductor layers by performing the metal-induced crystallization;
a second operation of forming one sub-mold layer, among the plurality of sub-mold layers, that surrounds a portion of a side surface of the one sub-sacrificial semiconductor layer;
a third operation of forming a support pattern that covers a side surface of an upper portion of the one sub-sacrificial semiconductor layer; and
repeating the first operation, the second operation, and the third operation are at least three times.

12. The method of claim 11, wherein a plurality of the support patterns are formed, and the plurality of support patterns respectively cover side surfaces of upper portions of the plurality of sub-sacrificial semiconductor layers,
wherein the plurality of support patterns comprise a plurality of support holes respectively filled with portions of the plurality of sub-sacrificial semiconductor layers, and
wherein the plurality of support holes of the plurality of support patterns have a same horizontal width.

13. The method of claim 11, wherein a plurality of the support patterns are formed, and the plurality of support patterns respectively cover side surfaces of upper portions of the plurality of sub-sacrificial semiconductor layers,
wherein the plurality of support patterns comprise a plurality of support holes respectively filled with portions of the plurality of sub-sacrificial semiconductor layers, and
wherein, for two support patterns adjacent to each other in the vertical direction among the plurality of support patterns, a support hole of a support pattern at a higher level has a horizontal width greater than a horizontal width of a support hole of a support pattern at a lower level.

14. The method of any of claims 1-6 wherein:
the method further comprises forming a plurality of word lines, a plurality of back gate lines, and a plurality of bit lines on the substrate, wherein the plurality of word lines extend in a first horizontal direction, wherein the plurality of back gate lines extend in the first horizontal direction and are spaced apart from the plurality of word lines in a second horizontal direction different from the first horizontal direction,
forming a channel structure comprises forming a plurality of channel patterns, wherein the plurality of channel patterns are arranged between one word line, among the plurality of word lines, and one back gate line adjacent to the one word line, among the plurality of back gate lines, the plurality of channel patterns extending in a vertical direction, and wherein the plurality of bit lines extend below the plurality of channel patterns in the second horizontal direction different from the first horizontal direction and are electrically connected to first ends of the plurality of channel patterns;
the method further comprises forming a plurality of connection structures by implanting impurities into upper portions of the plurality of channel patterns;
forming the silicide material layer comprises forming, on the plurality of connection structures, a plurality of silicide material layers, each silicide material layer of the plurality of silicide material layers comprising an alloy of a semiconductor material and a metal, each silicide material layer comprising a eutectic composition;
forming the sacrificial semiconductor layer comprises forming a plurality of sacrificial semiconductor layers, the mold layer, and a plurality of support patterns on the plurality of connection structures;
forming the capacitor hole comprises forming a plurality of capacitor holes by removing the plurality of sacrificial semiconductor layers;
forming the lower electrode comprises forming a plurality of lower electrodes that respectively fill the plurality of capacitor holes and are respectively electrically connected to second ends of the plurality of channel patterns;
the capacitor dielectric layer is formed to cover surfaces of the plurality of lower electrodes and surfaces of the plurality of support patterns;
each sacrificial semiconductor layer of the plurality of sacrificial semiconductor layers comprises a plurality of sub-sacrificial semiconductor layers having a cylindrical shape, and the mold layer comprises a plurality of sub-mold layers, and
the forming the plurality of sacrificial semiconductor layers, the mold layer, and the plurality of support patterns comprises:
heating and converting the plurality of silicide material layers into a plurality of induced silicide material layers having a circular planar shape;
a first operation of forming, between the plurality of induced silicide material layers and upper surfaces of the plurality of connection structures, one sub-sacrificial semiconductor layer, among the plurality of sub-sacrificial semiconductor layers, by injecting a semiconductor material precursor and performing a metal-induced crystallization;
a second operation of forming one sub-mold layer, among the plurality of sub-mold layers, that surrounds a portion of a side surface of the one sub-sacrificial semiconductor layer;
a third operation of forming one support pattern, among the plurality of support patterns, which covers a side surface of an upper portion of the one sub-sacrificial semiconductor layer; and
repeating the first operation, the second operation, and the third operation at least three times.

15. The method of claim 14, wherein each sub-sacrificial semiconductor layer of the plurality of sub-sacrificial semiconductor layers has a constant horizontal width from a lowermost end to an uppermost end of each sub-sacrificial semiconductor layer.
